# EUROPEAN PATENT APPLICATION

(11) **EP 4 841 289 A1**
(43) Date of publication of application: **18.11.2026**
(21) Application number: 25176657.2
(22) Date of filing: 15.05.2025
(51) Int. Cl.: G01R 33/38, G01R 33/50

(54) **SCANNING DEVICE AND METHOD FOR DETERMINING A RELAXATION TIME**

(71) Applicant: Siemens Healthineers AG, 91301 Forchheim (DE); Zetta25 AG, 8047 Zurich (CH)
(72) Inventor: LAUER, Lars, 91077 Neunkirchen (DE); POPESCU, Stefan, 91056 Erlangen (DE); KRÜGER, Gunnar, 4102 Binningen (CH); AMOR, Nadia, 55130 Mainz (DE)

(57) **Abstract**

The invention relates to a scanning device (10) configured to determine a spin-spin relaxation time of an object, comprising: a probe (30) configured to be positioned variably relative to a section of the object; a magnet arrangement (13) comprising at least one magnet (17); and a high frequency system comprising at least one high frequency coil (28); wherein the at least one magnet (17) and/or the at least one high frequency coil (28) are mounted on the probe (30), and wherein the probe (30) is configured to acquire information on the spin-spin relaxation time of the section of the object. The current invention further concerns a method for determining a spin-spin relaxation time of an object using a scanning device (10), comprising: positioning (S10) the probe (30) relative to a section of the object; and acquiring (S20) information on the spin-spin relaxation time of the section of the object.

## Description

Independent of the grammatical term usage, individuals with male, female or other gender identities are included within the term.

The current invention concerns a scanning device configured to determine a relaxation time of an object, and a method for determining a relaxation time of an object using a scanning device.

Magnetic resonance imaging (MRI) is a widely used medical imaging technique that provides detailed images of internal body structures. Conventional MRI systems typically require large, stationary equipment and dedicated facilities. Particularly, MRI systems rely on strong magnets, high frequency systems, and gradient systems to generate images based on magnetic properties of tissues.

In recent years, there has been increasing interest in developing more compact and portable MRI devices for specialized applications, such as dental imaging. Dental MRI offers potential advantages over traditional X-ray imaging by avoiding ionizing radiation exposure and providing superior soft tissue contrast. However, implementing MRI technology in dental settings presents several challenges.

One challenge is creating a sufficiently strong and uniform magnetic field within the confined space of the oral cavity. Traditional MRI systems use large superconducting magnets, which are impractical for both dental applications and dental facilities. Another difficulty lies in designing high frequency coils that can effectively transmit and receive signals in the complex geometry of the mouth and jaw region. Furthermore, conventional MRI systems rely on gradient coils for spatial encoding, which add costs, complexity and size to the equipment.

Existing approaches to dental MRI often involve compromises in field strength, image quality, or ease of use. Some dedicated dental MRI systems require patients to position their heads within small bore magnets, which can be uncomfortable and limit access for dental procedures. Other designs use external surface coils, but these may provide limited signal penetration to deeper oral structures and do not solve the problems of high costs, low accessibility to dental structures and/or significant space requirements associated with traditional MRI systems.

A scanning device is needed that addresses these limitations for determining tissue properties in dental applications, but also other diagnostic and non-diagnostic applications.

Hence, it is an object of the current invention to provide a scanning device and method for determining a relaxation times of an object without requiring large, stationary equipment or gradient coils for spatial encoding.

This object is achieved by a scanning device and a method according to the independent claims. Further advantageous embodiments are specified in the dependent claims.

In a first aspect, the invention relates to a scanning device. The scanning device is configured to determine a spin-spin relaxation time of an object. The scanning device comprises a probe configured to be positioned variably relative to a section of the object. The scanning device also includes a magnet arrangement and a high frequency system. The magnet arrangement comprises at least one magnet and the high frequency system comprises at least one high frequency coil. The at least one magnet and/or the at least one high frequency coil are mounted on the probe. The probe is configured to acquire information on the spin-spin relaxation time of the section of the object.

The scanning device is configured to determine a spin-spin relaxation time of an object. The scanning device can comprise various components and systems to enable this functionality.

The probe can be configured to contain or support other components of the scanning device, such as the at least one magnet and/or the at least one high frequency coil. The probe may be configured to enable flexible positioning of components mounted on the probe to examine different areas of interest on the object. The probe can be a handheld instrument or tool that an operator can manipulate to place in proximity to or in contact with the object being examined.

The probe may enable a correlation between acquired spin-spin relaxation times and a spatial position of the probe as determined by an operator of the scanning device, alleviating or eliminating the need for large and expensive gradient systems. Furthermore, the probe may allow for a placement of the at least one magnet and/or the at least one high frequency coil in direct proximity to a specific area of the object to be examined, allowing the use of smaller magnets and/or high frequency coils in comparison to conventional MRI systems.

The magnet arrangement may be configured to generate a magnetic field in the vicinity of the object being examined. The magnet arrangement may comprise a permanent magnet, an electromagnet, or a combination thereof. The magnetic field generated by the magnet arrangement may be configured to align nuclear spins in the object for magnetic resonance measurements.

The high frequency system can be configured to emit high frequency pulses (or radiofrequency pulses) and/or detect magnetic resonance signals from the object. The high frequency coil may comprise an antenna element configured to transmit and/or receive electromagnetic waves or magnetic resonance signals in a frequency range relevant for magnetic resonance measurements.

The at least one magnet and/or the at least one high frequency coil can be mounted on the probe. Mounting the at least one magnet and/or the at least one high frequency coil on the probe may allow for the magnetic field generation, but also the transmission and/or reception of high frequency signals, to be localized near the tip of the probe for targeted measurement of a section of the object.

The Spin-spin relaxation time, also known as T2 relaxation time, may be understood as a measure of how quickly the transverse component of magnetization decays in magnetic resonance measurements. For example, the spin-spin relaxation time may represent a physical property that describes how quickly nuclear spins in a material lose coherence with each other. This relaxation process is influenced by interactions between neighbouring nuclear spins and can provide information about the molecular environment and/or dynamics within the material.

According to an embodiment, the spin-spin relaxation time provides information about the molecular environment and/or mobility of protons in a sample or tissue. The probe and/or the scanning device may be configured to emit high frequency pulses and detect the resulting magnetic resonance signals, from which the spin-spin relaxation time can be determined. The spin-spin relaxation time may also provide information about the molecular environment and/or mobility of water molecules in the examined tissue. The spin-spin relaxation time can be useful for detecting pathological changes in tissues, such as inflammation.

An object may comprise or consist of any material or substance that can be examined using magnetic resonance techniques. This can include biological tissues, industrial materials, or any other sample of interest. In some applications, the object may represent a patient, such as a human or an animal.

A section of the object may refer to a specific region or volume of the object that is targeted for measurement. For example, the section of the object may represent an oral cavity or a tissue within the oral cavity of a patient. The ability to position the probe variably allows for selective examination of different sections of the object.

The at least one magnet may comprise or consist of a permanent magnet or an electromagnet. The at least one magnet may be configured to generate a magnetic field. The magnetic field may enable an alignment of nuclear spins in the object. The at least one magnet may be arranged on the probe or separate from the probe.

The high frequency coil may be configured to transmit high frequency pulses and/or receive magnetic resonance signals. For example, the high frequency coil may be configured to excite nuclear spins within the object and/or receive magnetic resonance signals from the object. The high frequency coil may comprise a receive coil and/or a transmit coil.

The at least one magnet and/or the at least one high frequency coil may be mounted on the probe. According to an embodiment, the at least one magnet and the high frequency coil are mounted on the probe. However, it is also conceivable that only the at least one magnet or the high frequency coil is mounted on the probe. A probe carrying at least one magnet and/or at least one high frequency coil may allow for localized magnetic field generation and/or signal management in close proximity to an area of the object being examined.

To determine the spin-spin relaxation time, the scanning device may be configured to apply a series of high frequency pulses and measure the resulting magnetic resonance signal decay over time. The scanning device may comprise a control unit programmed or configured to execute appropriate pulse sequences, such as a Carr-Purcell-Meiboom-Gill (CPMG) sequence, to measure spin-spin relaxation times.

According to an embodiment, the inventive scanning device lacks a gradient system configured to generate magnetic field gradients for spatial encoding of magnetic resonance signals.

The scanning device may favourably enable targeted measurement of spin-spin relaxation times of specific areas of an object without requiring a full-scale magnetic resonance imaging system. This can allow for more accessible and cost-effective diagnostic capabilities in various medical and research applications. Particularly, the scanning device may allow for an acquisition of magnetic resonance signals without relying on large and expensive magnets and/or gradient coils, but also a cooling infrastructure associated with these components.

In an embodiment of the scanning device, a section of the probe comprising the at least one magnet and/or the high frequency coil is configured to be inserted into an oral cavity of a patient. The probe may be configured to determine a spin-spin relaxation time of a tissue within the oral cavity of the patient.

An oral cavity may represent the interior space of the mouth, confined by the lips, cheeks, hard and soft palates, and throat. The oral cavity can comprise various anatomical structures including the teeth, gums, tongue, palate, and salivary glands. The oral cavity may provide access for the probe to enable examining dental and/or periodontal tissues.

The tissue within the oral cavity may comprise any soft and/or hard biological material present in the mouth. For example, the tissue may comprise gingival tissue (gums), periodontal ligaments, alveolar bone, dental pulp, tooth roots, but also enamel and other tissues within the oral cavity. The scanning device may enable examination of spin-spin relaxation times of these tissues to detect potential pathologies or abnormalities, such as inflammation and/or infection.

Determining a spin-spin relaxation time may comprise characterizing tissue properties based on how quickly protons in the tissue de-phase after excitation. The scanning device may be configured to utilize this phenomenon to differentiate between healthy and potentially inflamed or diseased tissues in the oral cavity.

The probe can be configured to be inserted into the oral cavity, enabling positioning close to tissues of interest for examination. This configuration allows the scanning device to access areas within the mouth that may be difficult to reach when using conventional magnetic resonance imaging systems. Furthermore, the probe's ability to be inserted into the oral cavity enables localized measurements of specific dental and periodontal structures, but also the use of a smaller magnet arrangement in comparison to conventional magnetic resonance imaging systems comprising magnets enclosing sections of the object.

The probe of the scanning device can be designed and dimensioned to fit comfortably and safely within the oral cavity. The probe may have an elongated shape to reach different areas within the mouth. The probe may comprise a tip configured to enter the oral cavity. The tip can be made of a biocompatible material to prevent any adverse reactions of tissues within the oral cavity.

The spin-spin relaxation time of a tissue within the oral cavity may provide valuable diagnostic information. The spin-spin relaxation time can be indicative of tissue properties and can help identify abnormalities or pathological conditions. For example, inflamed or infected tissues may exhibit different spin-spin relaxation times compared to healthy tissues.

The magnet arrangement may be configured to provide a magnetic field localized to a small volume near the probe tip to enable targeted measurements of specific areas of interest within the mouth. According to an embodiment, the at least one magnet is mounted on the tip of the probe. The at least one magnet may be configured to generate a localized magnetic field near the tip of the probe.

According to an embodiment, the at least one high frequency coil is mounted on the tip of the probe. The high frequency coil may comprise a receive coil configured for detection of magnetic resonance signals within the confined space of the oral cavity. For example, the high frequency coil may be configured to provide high sensitivity in a small detection volume to capture signals from tissues in close proximity to the probe tip. Alternatively or additionally, the at least one high frequency coil mounted on the tip of the probe may comprise a transmit coil configured to emit high frequency pulses into a tissue in close proximity to the probe tip.

The ability to insert the probe into the oral cavity and obtain localized measurements of spin-spin relaxation times can provide several advantages. For example, the scanning device may enable non-invasive assessment of oral tissues without the need for tissue sampling. Furthermore, the compact and portable nature of the scanning device may allow for point-of-care diagnostics in dental offices or clinical settings. Additionally, a localized measurement of spin-spin relaxation times can provide high sensitivity for detecting abnormalities in specific tissues of the mouth.

A measurement time for a single tooth or area of interest can be between 1 and 5 seconds, enabling efficient examination of multiple areas within the oral cavity during a scanning session. The measurement time may be decreased through optimized pulse sequences and data acquisition strategies tailored for the specific requirements of dental applications. A low measurement time may favourably enhance patient comfort and increase the efficiency of diagnostic procedures in dental settings.

In an embodiment of the scanning device, the probe is configured as a handheld probe. The handheld probe can be configured to be positioned freely relative to the section of the object.

A handheld probe can be configured as a portable, manually operated device that an operator can hold and manipulate freely to position relative to a section of an object being examined. The handheld probe can be configured to be lightweight and/or ergonomically designed for comfortable gripping and manoeuvring by hand.

The handheld probe may comprise a handle portion and a tip portion. The handle portion can be configured to be grasped by an operator's hand, while the tip portion can be configured to be positioned in proximity to or in contact with the object being examined. The handle portion may incorporate controls such as buttons or switches to allow the operator to control functions of the scanning device, such as scanning parameters. The handle portion may also incorporate an output unit according to an embodiment described below.

The handheld probe can be configured to allow an operator to freely move and orient the probe in three-dimensional space relative to the object. Thus, the handheld probe may enable the operator to flexibly and precisely target specific areas of interest on or within the object for examination. The handheld nature of the probe can provide flexibility in accessing different sections or angles of the object that may be difficult to reach with fixed or stationary equipment.

The handheld probe can be configured to be inserted into body cavities or positioned against external body surfaces to acquire diagnostic information. For dental applications, the tip of the handheld probe can be configured to be inserted into a patient's oral cavity and manoeuvred to examine different areas of the teeth, gums, and/or other tissues within the oral cavity.

The handheld probe can be configured to house or carry various components, such as a sensor, the at least one magnet, the at least one high frequency coil, and/or other measurement devices, at its tip. These components can be configured to interact with the object being examined to acquire data when the probe is positioned appropriately by the operator. The probe can also be configured with controls, buttons, and/or triggers on the handle portion to allow the operator to initiate measurements or adjust settings, such as scanning parameters.

A handheld probe configured for free positioning can offer advantages such as improved accessibility to confined spaces, ability to quickly survey target areas and/or multiple areas, and intuitive operation based on the operator's tactile feedback and visual observations. The handheld nature can also facilitate portable use in different locations or examination rooms. For example, the probe may provide portability, enabling the scanning device to be easily transported between examination rooms or facilities. Thus, the scanning device may provide increased flexibility of use compared to large stationary scanning systems.

At a distal end or tip of the handheld probe, a sensing portion can be arranged. The sensing portion may comprise the at least one magnet arrangement and/or the at least one high frequency coil. The sensing portion can be configured with a small form factor to allow access to confined spaces.

The handheld probe may enable the operator to manually position and orient the sensing portion relative to the object or tissue of interest, allowing targeted measurement of specific areas or tissues by placing the sensing portion in close proximity. The operator can sweep or scan the handheld probe across a surface to survey or scan target areas. Thus, the operator may favourably determine a pace of an examination in dependence of the target area, but also a potential pathology and/or need of a patient.

The handheld probe may favourably allow examination of objects or patients in various orientations and positions. For example, the probe can be used to examine a standing, sitting, or reclined patient. The probe may be configured to access different surfaces and/or cavities of an object or patient.

To facilitate precise positioning, the handheld probe can incorporate visual, auditory, or haptic feedback to guide the operator. For example, LEDs or a display on the handle can indicate proper positioning. Alternatively, vibration or tones can signal when the probe is optimally positioned.

The handheld probe may favourably enable localized, targeted measurement of spin-spin relaxation times in specific areas of interest, while maintaining flexibility and ease of use. The free positioning capability may favourably allow the scanning device to adapt to different examination scenarios and object geometries.

In an embodiment of the scanning device, the magnet arrangement is configured to encompass an external surface of the object, and the at least one high frequency coil is mounted on the probe.

An external surface of the object may represent an outer surface or boundary of the object that is accessible from the outside. The external surface may comprise any exposed area of the object that can be contacted or observed without penetrating into the interior of the object. For example, in the case of a patient's body, the external surface may include the skin, hair, nails, or other externally visible or accessible parts. In some embodiments, the external surface includes the skin and/or facial features around a jaw region of a patient.

The magnet arrangement may be shaped or arranged in such a way to surround, enclose, or wrap around at least a portion of the external surface of the object. The magnet arrangement may be configured to conform to contours of the external surface of the object, providing coverage over a desired area. For example, the magnet arrangement may be shaped to fit around a patient's jaw or head. In some embodiments, the magnet arrangement may comprise a U-shaped, a C-shaped, or a V-shaped section configured to accommodate a body part of a patient, such as a leg, an arm, or the head.

According to an embodiment the high frequency system comprises at least one surface coil configured to encompass an external surface of the object.

A surface coil can be configured as a type of high frequency coil used in magnetic resonance imaging that is placed directly on or very close to the surface of the object being imaged. Surface coils may be configured to provide a high signal-to-noise ratio for tissues near the surface of the object. The surface coil may be flexible or rigid. The surface coil can be shaped to conform to the external surface of the object, such as the jaw area of a patient. For example, the surface coil may be configured as a loop coil, an array coil, or other geometry optimized for the anatomy being examined. The surface coil can be configured to transmit high frequency pulses into the object and/or receive magnetic resonance signals from the object.

The high frequency system may include one or more surface coils that are designed to wrap around, cover, or conform to the external surface of the object being examined. The surface coil or surface coils may be configured to provide optimal coverage of an area of interest on the external surface of the object. For example, in a dental application, a surface coil may be configured to wrap around a patient's jaw to receive signals from the teeth, gingiva and surrounding tissues.

The at least one high frequency coil is mounted on the probe. The at least one high frequency coil may be physically attached to, integrated with, or supported by a body of the probe. Thus, the at least one high frequency coil may be positioned along with the probe relative to the object being examined. The at least one high frequency coil may comprise a receive coil and/or a transmit coil. For example, a small receive coil may be mounted at the tip of the probe for localized signal detection. Additionally or alternatively, a small transmit coil may be mounted at the tip of the probe for localized signal emission. Mounting the at least one high frequency coil on the probe may allow for localized excitation of nuclear spins and/or detection of magnetic resonance signals in specific areas of interest within the object.

A magnet arrangement encompassing an external surface of the object may provide a magnetic field that extends over a larger volume compared to a magnet mounted on the probe. Furthermore, an alignment of nuclear spins within a magnetic field generated by a magnet arrangement encompassing an external surface of the object may favourably be independent of a spatial position of the probe.

The magnet arrangement can comprise one or more permanent magnets and/or electromagnets configured to generate a static magnetic field suitable for magnetic resonance measurements.

The combination of a magnet arrangement encompassing the external surface of the object and at least one high frequency coil mounted on the probe may enable flexible and targeted examination of specific areas of the object. The magnet arrangement can provide a sufficiently uniform magnetic field over a region of interest, while the at least one high frequency coil on the probe may allow for targeted excitation of nuclear spins and/or detection of magnetic resonance signals. An optional surface coil configured to encompass the external surface of the object may provide additional coverage and/or sensitivity for signal reception.

A magnet arrangement encompassing the section of the object may favourably provide for a more uniform alignment of nuclear spins within the generated magnetic field. In providing a magnet arrangement separate from the probe, the alignment of the nuclear spins may be independent of a spatial position of the probe, potentially facilitating a process of determining spin-spin relaxation times.

A localized high frequency coil mounted on the probe may enable precise targeting of specific areas of the object, which can be particularly useful for dental or other localized applications.

In a further embodiment of the scanning device, the at least one magnet is mounted on the probe.

According to an embodiment, the at least one magnet is a unilateral magnet configured to project a magnetic field at a predefined distance from a tip of the probe.

The at least one magnet can be configured to generate a localized magnetic field in proximity to the tip of the probe. The at least one magnet can be arranged on or within the probe in such a way that a magnetic field is generated in proximity to the tip of the probe. A magnet mounted to the tip of the probe may favourably enable generation of a localized magnetic field for targeted measurement of spin-spin relaxation times in specific areas or tissues of the object.

A predefined distance may refer to a predetermined spatial separation between the tip of the probe and a region where the magnetic field is projected. In some embodiments, the tip of the probe corresponds to a pole face of the at least one magnet. The predefined distance can be selected based on the specific application and the desired depth of tissue measurement. The predefined distance can range from a fraction of a millimetre to several centimetres, depending on the design of the magnet arrangement and the intended use of the scanning device.

According to an embodiment, a volume with highest homogeneity or uniformity within the magnetic field generated by the magnet arrangement may be spaced from the tip of the probe by a distance of at least 0.5 mm, 1 mm, 1.5 mm, 2 mm, 2.5 mm, 3 mm, 3.5 mm, 4 mm, 4.5 mm, or 5 mm. It is also conceivable that the volume with highest homogeneity within the magnetic field is spaced from a pole face (e. g. a surface of the at least one magnet oriented towards the volume with the highest homogeneity) of the at least one magnet by a distance of at least 0.5 mm, 1 mm, 1.5 mm, 2 mm, 2.5 mm, 3 mm, 3.5 mm, 4 mm, 4.5 mm, or 5 mm.

The at least one magnet may be configured to generate a projected and/or localized magnetic field which provides sufficient signal-to-noise ratio for magnetic resonance measurements while limiting or minimizing the size and/or dimension of the at least one magnet.

Projecting a magnetic field may refer to the process of generating a magnetic field that is shifted with respect to a geometric centre point of the at least one magnet or extends beyond a physical boundary of the at least one magnet. A projected magnetic field may favourably enable the measurement of spin-spin relaxation times in a tissue of interest located a predefined distance away from the tip of the probe and/or the pole face of the at least one magnet.

A scanning device comprising a magnet configured to project a magnetic field at a predefined distance from the tip of the probe may provide several advantages. For example, the scanning device may allow for non-invasive measurement of tissue properties without requiring direct contact between the at least one magnet and the tissue. Moreover, the scanning device may provide flexibility in targeting specific tissue depths by adjusting a spatial position of the at least one magnet or replacing the at least one magnet to adapt the predefined distance or the generated magnetic field strength. In certain embodiments, the probe may be configured to mount different magnets or magnet arrangements configured to provide different magnetic fields and/or predefined distances in dependence of a tissue to be examined.

The at least one magnet may be configured to generate a magnetic field strength between 30 mT and 200 mT when mounted on the probe. This range of magnetic field strengths can be suitable for acquiring magnetic resonance signals from tissues in close proximity to the probe tip. The magnetic field strength can be selected based on factors such as the type of tissue being examined, the desired signal-to-noise ratio, and specific requirements of the measurement, but also the patient.

According to an embodiment, the magnet arrangement comprises the at least one magnet or consists of the at least one magnet. The magnet arrangement may comprise one or more magnets mounted to the probe. It is also conceivable that the magnet arrangement is mounted on the probe.

The at least one magnet or the magnet arrangement mounted to the tip of the probe may comprise a concave magnet design. For example, the at least one magnet or the magnet arrangement may comprise a U-shape, a C-shape, a V-shape, or any other suitable concave shape. A concave magnet design may be configured to provide or project a magnetic field within a volume at least partially enclosed by the at least one magnet or the magnet arrangement. The magnetic field may be provided or projected at a predefined distance from the tip of the probe and/or a pole face of a magnet of the magnet arrangement. Additionally, the concave magnet design may allow for a portion of the object to be at least partially encompassed by the at least one magnet or the magnet arrangement, potentially allowing for the object to be positioned in section of the magnetic field comprising a higher magnetic field uniformity. A concave magnet design may favourably provide a more uniform magnetic field in a region of interest compared to a single straight magnet, potentially allowing more accurate spin-spin relaxation time measurements.

The at least one magnet or the magnet arrangement mounted on the probe may be configured to enable measurement of tissue volumes between 0.5 cm³ and 2 cm³. However, the probe may be configured to enable measurement of smaller or larger tissue volumes depending on the size and design of the of the magnet arrangement. This volume range can be suitable for examining selected areas within the oral cavity, such as individual teeth or sections of gum tissue.

A scanning device comprising at least one magnet mounted on a probe may provide several technical advantages. The scanning device may allow for generation of a localized magnetic field enabling targeted measurement in specific areas of interest without the need for large magnets encompassing portions of the object. Thus, a more compact and/or portable scanning device suitable for use in dental offices may be provided.

The at least one magnet may comprise a unilateral magnet configured to project a magnetic field at a predefined distance from a tip of the probe. A unilateral magnet can be configured as a magnet that generates a magnetic field predominantly on one side or in one direction. The unilateral magnet can be designed to project a magnetic field into a specific region of space, typically in front of or to one side of the unilateral magnet.

The unilateral magnet can be configured to generate a directed or projected magnetic field that extends primarily in one direction from the tip of the probe or a pole face of the unilateral magnet.

The unilateral magnet may comprise various designs and configurations. For example, the unilateral magnet may comprise one or more permanent magnets arranged in a concave shape, such as a U-shape or a C-shape, where the magnetic field is concentrated in a gap or recess formed in a pole face of the unilateral magnet. In a further example, the unilateral magnet may comprise a Halbach array, which is an arrangement of permanent magnets that augments the magnetic field on a first side of the Halbach array while decreasing or cancelling the magnetic field on a second side 7of the Halbach array opposing the first side.

The at least one magnet may comprise or consist of materials such as neodymium iron boron (NdFeB), samarium cobalt (SmCo), or other rare earth magnetic materials that provide strong magnetic fields in compact sizes. The size and strength of the at least one magnet can be selected based on the desired magnetic field strength and/or depth of penetration for the specific application of the scanning device.

The use of a unilateral magnet in the scanning device may provide advantages such as reduced overall size and weight of the probe, improved manoeuvrability in confined spaces like the oral cavity, and/or the ability to perform localized measurements without the need for a large magnet system encompassing the object or sections of the object.

The at least one magnet may comprise an electromagnet or a permanent magnet. An electromagnet can be configured to generate a magnetic field when an electric current passes through it. The electromagnet may comprise a coil of wire wrapped around a core material, such as iron. When electric current flows through the coil of wire, a magnetic field can be generated. The strength of the magnetic field can be controlled by adjusting the amount of current flowing through the coil.

The use of an electromagnet may provide several advantages. The magnetic field strength can be adjusted by varying the electric current, allowing for flexibility in a measurement process. The magnetic field can be turned on and off as needed, which can be beneficial for power management and/or safety considerations. Additionally, the polarity of the magnetic field can be reversed by changing the direction of the electric current, which can be useful for certain measurement techniques.

According to an embodiment of the scanning device, the high frequency system comprises a receive coil and a transmit coil. The receive coil can be mounted on the probe. The transmit coil can be formed as a surface coil configured to encompass an external surface of the object.

A receive coil can be configured to detect magnetic resonance signals emitted by excited nuclear spins in the object being scanned. The receive coil can be designed to be sensitive to weak electromagnetic signals produced by the precessing nuclear spins as they return to their equilibrium state. The receive coil can be configured to convert these electromagnetic signals into electrical signals that can be processed to obtain information about the object being scanned.

A transmit coil may be configured to emit high frequency pulses into the object to excite nuclear spins in the object. The transmit coil can be configured to generate the high frequency pulses used to excite the nuclear spins in the object being scanned. The transmit coil can be designed to produce a uniform high frequency field (e.g. a B1-field) over a region of interest in the object.

The receive coil can be configured to detect magnetic resonance signals emitted by the object in response to excitation by the transmit coil. The receive coil can comprise one or more antenna elements configured to receive electromagnetic waves in the frequency range of a magnetic-resonance-active atomic nucleus. The receive coil can be arranged at or near the tip of the probe to allow for localized signal detection from tissues in close proximity to the probe.

Mounting the receive coil on the probe may allow for the receive coil to be positioned in close proximity to the area of interest on the object being examined, enabling improved signal detection and higher sensitivity in a small, well-defined area or volume of the object. This may favourably allow for received magnetic resonance signals to be attributed to a specific volume covered by the receive coil, eliminating the need for a dedicated gradient system.

The transmit coil may be formed as a surface coil configured to encompass an external surface of the object. A surface coil may comprise one or more antenna elements arranged to conform to a surface contour of the object being examined.

The transmit coil may comprise one or more antenna elements arranged in a planar or curved geometry to conform to the external surface of the object. For dental applications, the transmit coil can be shaped to fit around the jaw area of a patient.

A transmit coil configured as a surface coil encompassing an external surface of the object may allow for efficient transmission of high frequency pulses into the object, but also a more uniform excitation of nuclear spins in the object compared to a coil mounted on the probe.

The combination of a receive coil mounted on the probe and a transmit coil formed as a surface coil may provide advantages in terms of signal detection sensitivity and excitation efficiency. The receive coil mounted on the probe may be positioned close to the region of interest, while the larger surface transmit coil may provide a broader and/or more uniform excitation of nuclear spins in the objects.

The scanning device may comprise a control unit configured to coordinate the operation of the transmit coil and the receive coil. For example, the control unit may be configured to control the transmit coil to emit one or more high frequency pulses and coordinate the timing of a readout of magnetic resonance signals via the receive coil with the one or more high frequency pulses.

The scanning device may further comprise a processing unit configured to process the received magnetic resonance signals and extract information on the spin-spin relaxation time of the section of the object.

A scanning device comprising a localized receive coil with a transmit coil configured as a surface coil may provide enhanced flexibility in scanning different regions of the object. For example, the scanning device may allow movement of the probe with the receive coil to specific areas of interest, while the transmit coil maintains a consistent excitation over a broader region of the object. This configuration of the scanning device may favourably provide improved signal quality and/or enable a more precise measurement of the spin-spin relaxation times in specific regions of interest. Furthermore, a limited detection volume provided by a receive coil mounted to the probe may allow for an assignment of received magnetic resonance signals to a specific volume covered by the receive coil, advantageously eliminating the need for a dedicated gradient system.

In a further embodiment of the scanning device, the high frequency system comprises a receive coil and a transmit coil. The transmit coil can be mounted on the probe. The receive coil can be formed as a surface coil configured to encompass an external surface of the object.

An antenna element may constitute a coupling element between electromagnetic waves conducted in signal conductors and free electromagnetic waves, i. e. electromagnetic waves located in a free space.

A transmit coil may comprise an antenna element configured to transmit or emit electromagnetic waves in the frequency range of a magnetic-resonance-active atomic nucleus. Electromagnetic waves relevant to magnetic resonance measurements may represent high frequency signals or pulses comprising frequencies between 1 and 500 MHz, preferably between 10 and 300 MHz. The transmitted electromagnetic waves may exhibit a power of a few watts up to several kilowatts. The transmit coil may comprise one or more antenna elements. The antenna elements can be arranged spaced apart from one another, adjacent to one another or partially overlapping. It is also conceivable that the antenna elements can be arranged in the form of a grid, an array or a matrix.

The term mounting may refer to the process of physically attaching or fixing one component to another. For example, mounting the transmit coil on the probe can involve securely attaching the transmit coil to a surface or within a housing of the probe. This mounting can be achieved through various means, such as screws, adhesives, clips, or integration into the probe's structure during manufacturing. The mounting can be configured to ensure proper alignment and positioning of the transmit coil relative to other components of the scanning device. Of course, other components of the scanning device may be mounted to the probe in a similar manner.

Mounting the transmit coil on the probe may favourably enable localized excitation of nuclear spins in close proximity to the probe tip. A transmit coil mounted on the probe may allow for targeted excitation of specific regions of interest within the object. The transmit coil can be designed to generate a localized high frequency field, which can be advantageous for reducing the overall power requirements of the scanning device and minimizing potential heating effects in the object. The transmit coil mounted on the probe may be configured to provide a small restricted transmit profile resulting in a reduced or confined volume for the excitation of nuclear spins. This may favourably allow for received magnetic resonance signals to be attributed to the confined volume covered by the transmit coil, eliminating the need for a dedicated gradient system.

The receive coil may comprise an antenna element configured to receive magnetic resonance signals. The magnetic resonance signals may represent electromagnetic waves in the frequency range of a magnetic-resonance-active atomic nucleus. Electromagnetic waves relevant to magnetic resonance measurements can represent radiofrequency signals comprising frequencies between 1 and 500 MHz, preferably between 10 and 300 MHz. The magnetic resonance signals may exhibit a low power of a few microwatts up to several milliwatts.

The receive coil may comprise one or more antenna elements. The antenna elements can be arranged spaced apart from one another, adjacent to one another or partially overlapping. Furthermore, the antenna elements can be arranged in the form of a grid, an array or a matrix. The antenna elements may be arranged in a planar or curved configuration to conform to the external surface of the object.

A surface coil can be configured as a type of receive coil and/or transmit coil that is designed to be placed directly on or near a surface of the object being examined. The surface coil can be configured to encompass an external surface of the object, such as a patient's body part. The surface coil can be shaped to conform to contours of the object's surface, allowing for improved signal reception and/or transmission in localized areas. Surface coils can be particularly useful for examining specific regions of interest with high signal-to-noise ratio.

A receive coil formed as a surface coil may favourably enable the receive coil to encompass an external surface of the object, providing a larger detection area compared to a receive coil mounted on the probe. The larger surface area of a receive coil formed as surface coil may favourably enable better coverage of the region of interest, potentially allowing for capturing of magnetic resonance signals from a larger area or volume in comparison to a probe-mounted receive coil.

This configuration of the scanning device may favourably enable efficient and targeted acquisition of spin-spin relaxation times from specific regions of the object. The combination of a localized transmit capability with a broader receive capability may provide a balance between spatial specificity and signal sensitivity, potentially improving the overall performance of the scanning device for determining spin-spin relaxation times. Furthermore, the smaller restricted transmit profile provided by the transmit coil mounted to the probe may allow for an assignment of received magnetic resonance signals to a confined volume, advantageously eliminating the need for a dedicated gradient system.

According to an embodiment of the scanning device, the high frequency system comprises a receive coil and a transmit coil. The receive coil and the transmit coil can be configured as surface coils configured to encompass an external surface of the object.

The receive coil and the transmit coil may form separate surface coils configured to be arranged adjacent to each other. However, the receive coil and the transmit coil may also form sections of a combined surface coil. For example, the receive coil and the transmit coil may be formed as layers of the combined surface coil. The separate surface coils or the combined surface coil can be configured to be placed directly on or very close to a surface of the object being scanned. The separate surface coils or the combined surface coil can be shaped or otherwise configured to conform to an external contour of the object, allowing for improved signal reception and/or transmission in specific regions of the object, such as the head region or the jaw region of a patient. By configuring the receive coil and the transmit coil as surface coils, the scanning device can achieve improved signal-to-noise ratio compared to volume coils, particularly for surface or near-surface tissues.

The term "encompass" in this context can mean that the receive coil and the transmit coil are configured to surround or cover a predefined portion of the external surface of the object.

The use of separate surface coils or a combined surface coil may favourably provide flexibility in optimizing the scanning device for different types of objects or different scanning protocols. For example, the transmit coil can be designed to provide a mostly uniform excitation field over a large volume, while the receive coil can be optimized for high sensitivity in specific regions of interest.

The scanning device comprising a receive coil and a transmit coil formed as surface coils preferably comprises at least one magnet mounted on the probe according to an embodiment described above. The at least one magnet may be configured to generate a small localized magnetic field or a small unilateral projected magnetic field. For example, the magnetic field may be large enough to cover soft tissue at the root of a tooth. As only the tissue covered by the small localized magnetic field will provide coherent magnetic resonance signals, received magnetic resonance signals can be attributed to a specific volume covered by the small localized magnetic field, eliminating the need for a dedicated gradient system.

The receive coil and the transmit coil may be connected to a high frequency control unit for signal transmission and reception. The high frequency control unit may include components such as preamplifiers, power amplifiers, and matching networks to coordinate the emission of high frequency pulses and the reception of magnetic resonance signals.

In providing a receive coil and a transmit coil formed as surface coils encompassing the external surface of the object, the scanning device may achieve several technical advantages, such as improved signal sensitivity for surface and near-surface tissues and/or the ability to conform the surface coils to the specific anatomy being examined. Furthermore, a combination of a receive coil and a transmit coil formed as surface coils with a magnet mounted on the probe may allow for an assignment of received magnetic resonance signals to a specific volume covered by a small localized magnetic field generated by the magnet, favourably eliminating the need for a dedicated gradient system.

In a further embodiment, the scanning device comprises an output unit. The output unit can be configured to output the information on the spin-spin relaxation time on the section of the object. The output unit can be configured to output the information in the form of an acoustic signal, an optical signal and/or a haptic signal.

The output unit may comprise a display, a speaker, a haptic feedback device, and/or other suitable means for conveying information to an operator. The output unit may be configured to produce one or more of these signal types to convey information about the measured spin-spin relaxation times to an operator. The output unit may favourably enable interpretation of acquired magnetic resonance signals during a scanning procedure.

An acoustic signal may comprise auditory feedback, such as an audible sound or tone produced by the output unit to convey information. For example, different tones or patterns of tones may indicate different spin-spin relaxation time values or ranges. It is also conceivable that different tones or patterns output by the are configured to indicate certain states of an examined tissue, such as a pathology or inflammation. A frequency, volume, or pattern of acoustic signal can be configured to correspond to different ranges or values of spin-spin relaxation times. For example, a higher pitch can be configured to indicate a longer spin-spin relaxation time, while a lower pitch can be configured to indicate a shorter spin-spin relaxation time.

An optical signal may comprise visual feedback and/or a visual indicator produced by the output unit, such as a light, a colour, or a graphical display. For instance, different lights, colours or light patterns displayed on a screen and/or an indicator light may correspond to different spin-spin relaxation time measurements and/or certain states of the examined tissue. The optical signal may comprise a visual display using various colours, intensities, or patterns of light. The optical signal may also be output by LED indicators, where different colours may represent different ranges of spin-spin relaxation times. However, the optical signal may also be output by a graphical display showing the spin-spin relaxation time data in real-time.

A haptic signal may comprise a tactile feedback produced by the output unit, such as a vibration or other physical sensations. An intensity, duration, or pattern of vibrations may be used to indicate different spin-spin relaxation time values and/or certain states of the examined tissue. For instance, a strong vibration may indicate spin-spin relaxation times outside a normal range, while a gentle vibration may indicate spin-spin relaxation times within an expected range.

The information on the spin-spin relaxation time may comprise numerical values, graphical representations, and/or other data formats representing the measured spin-spin relaxation times of the scanned object.

The scanning device may comprise a control unit and/or processing unit configured to process acquired magnetic resonance signals or spin-spin relaxation time data and generate appropriate output signals for the output unit. The processing of the acquired magnetic resonance signals or spin-spin relaxation time data can involve mapping measured values to predefined ranges or thresholds that correspond to different output signals.

Outputting the information on the spin-spin relaxation times may involve transmitting the processed magnetic resonance signals or spin-spin relaxation time data from a control unit and/or processing unit to the output unit and converting that data into a form perceptible to the operator via acoustic, optical, and/or haptic means.

The output unit may comprise various components for generating different types of signals. For acoustic signals, the output unit can include a speaker, buzzer, or other sound-generating device. For optical signals, the output unit can comprise one or more light-emitting elements such as LEDs, a display screen, or other visual indicators. For haptic signals, the output unit can include a vibration motor, actuator, or other component capable of producing tactile feedback.

The control unit and/or processing unit, but also the output unit, may be configured to encode the information on the spin-spin relaxation time in different ways depending on the signal type. For acoustic signals, variations in tone, volume, or rhythm may represent different spin-spin relaxation time values or ranges. Optical signals may comprise different colours, brightness levels, or blinking patterns. Haptic signals can vary in intensity, duration, or pattern of vibrations.

The output unit can be integrated directly into the probe of the scanning device, allowing the operator to receive immediate feedback while positioning and using the probe. Alternatively or additionally, the scanning device may comprise an output unit separate from the probe, such as an external display or speaker system.

Providing multiple output modalities through acoustic, optical, and/or haptic signals may allow for a flexible use of the scanning device in various clinical environments. The operator may choose the most suitable output type based on factors such as ambient noise levels, lighting conditions, but also personal preference.

The output unit may favourably enhance the usability of the scanning device by providing real-time feedback to an operator, potentially enabling more efficient and/or accurate positioning of the probe relative to the object being examined. The immediate output of information on spin-spin relaxation times may facilitate rapid identification of areas of interest, such as regions with abnormal tissue properties, without requiring the operator to constantly refer to a separate display or interface.

According to an embodiment, the scanning device comprises a sensor configured to acquire information on a spatial position of the probe.

The sensor can be configured to detect and measure various physical properties or quantities related to the position, orientation, and/or movement of the probe. The sensor can be implemented using various technologies, including but not limited to optical sensors, ultrasound sensors, Hall sensors, accelerometers, gyroscopes, magnetometers, and the like.

The sensor can be configured to provide data in various formats, such as analog signals, digital signals, and/or encoded data streams. This data may comprise position coordinates, angles, distances, velocities, accelerations, and/or other relevant spatial information.

The sensor can be mounted on the probe or can be arranged separately from the probe. For example, the sensor may be mounted in a fixed position separate from the probe or the object being examined. Multiple sensors of the same or different types can be used in combination to improve accuracy of the spatial information or provide redundancy.

The information or data acquired by the sensor can be used for various purposes, such as tracking the movement of the probe during a scanning procedure, correlating the spatial position of the probe with acquired spin-spin relaxation time data, adjusting measurement parameters based on the spatial position of the probe, providing feedback to the operator on the spatial position of the probe, and/or enabling spatial mapping of examined tissues or structures.

The sensor can be configured to operate in real-time, providing continuous updates on the spatial position of the probe. However, the sensor may also be configured to take measurements at discrete intervals or upon command.

The sensor can be configured to acquire information or data related to the spatial position of the probe. This data may include information about the location, orientation, and/or movement of the probe relative to a reference point or coordinate system. The sensor may be configured to continuously or periodically acquire this data as the probe is moved or positioned.

In the case of an optical sensor, the sensor can be configured to capture visual information about the probe, but also the probe's surroundings. For example, the optical sensor may be configured to capture image data and/or video data of an area around the probe, which can be analysed to determine the spatial position of the probe. The optical sensor or a control unit and/or processing unit of the scanning device can use techniques such as image recognition or pattern matching to identify landmarks or reference points in the captured images, which can be used to calculate the spatial position of the probe.

An ultrasound sensor can be configured to emit ultrasonic waves and detect their reflections. By measuring the time it takes for the waves to return and analysing the reflected signals, the ultrasound sensor can determine the distance and/or orientation of the probe relative to surrounding objects or surfaces.

A Hall sensor can be configured to detect changes in magnetic fields. The Hall sensor can measure the strength and direction of a magnetic field generated by the magnet arrangement, which can be used to infer the spatial position (e. g. the position and/or orientation) of the probe. For example, a control unit and/or processing unit of the scanning device may be configured to compare the field strength measured by the Hall sensor to a known magnetic field distribution provided by a magnet arrangement encompassing an external surface of the object.

A control unit and/or processing unit of the scanning device may be configured to process the information on the spatial position acquired by the sensor. This processing may involve the application of algorithms for interpreting raw sensor data and converting it into usable spatial position information.

A sensor configured to acquire information on the spatial position of the probe may offer several technical advantages. For example, the sensor can enable more precise and/or reproducible measurements by providing accurate information about where each measurement is taken. This can be particularly beneficial in applications where the exact location of a measurement is important, such as in dental or medical diagnostics. In a further example, the spatial information can be used to combine or fuse the spin-spin relaxation time data with the information on the spatial position of the probe. Thus, a need for a dedicated gradient system for spatial encoding of magnetic resonance signals may be eliminated. Moreover, the spatial information acquired via the sensor may assist in guiding the operator of the scanning device, potentially improving the ease of use and reducing the likelihood of errors in probe positioning.

In a further embodiment, the scanning device comprises an optical sensor. The optical sensor can be mounted on the probe. The optical sensor can be configured to acquire optical data from a surface of the section of the object.

An optical sensor can be configured as a device that detects and measures light or other electromagnetic radiation. The optical sensor can be configured to acquire optical data or visual information from the surface of the object being examined. The visual information can include images, videos, and/or other optical data that provides details about characteristics of the surface of the object being examined, such as texture, colour, topography, and/or other visible properties of the surface of the section of the object.

The optical sensor can be mounted on the probe. For example, the optical sensor may be physically attached to a structure of the probe and/or integrated into the structure of the probe. Various mounting methods can be utilized, such as adhesive bonding, mechanical fastening, or embedding within a material of the probe.

A surface of the section of the object may refer to an external or outermost layer of an area being examined. In the context of dental applications, this surface can be the visible portion of a tooth, the gum tissue, or other oral structures.

The optical sensor mounted on the probe may enable the scanning device to gather visual information about the examined area in addition to the information on the spin-spin relaxation times.

The visual information may be used for various purposes, such as identifying specific anatomical features, or guiding the positioning of the probe. A control unit and/or processing unit of the scanning device may be configured to correlate the visual information about the examined area with the information on the spin-spin relaxation times.

The optical sensor can be implemented using various technologies. For example, the optical sensor can comprise a camera, a digital camera, an infrared camera, a charge-coupled device (CCD) sensor, a complementary metal-oxide-semiconductor (CMOS) sensor, or any other suitable imaging device capable of capturing optical data. The optical sensor can be configured to capture data in visible light wavelengths, infrared, ultraviolet, or a combination thereof, depending on the specific application requirements.

By mounting the optical sensor on the probe, the optical sensor may be positioned in close proximity to the surface of an object being examined, allowing for high-resolution imaging, but also detailed surface analysis. The probe can be manoeuvred to different positions relative to the object, allowing the optical sensor to capture optical data from the surface of the section of the object from various angles and locations.

The acquired optical data can be used for various purposes in conjunction with the information on the spin-spin relaxation time. For example, the optical data can provide contextual information about the surface of an object being examined, which can be correlated with the spin-spin relaxation time data to provide a more comprehensive analysis of the section of the object. The optical data can also be used for navigation and positioning of the probe, enabling precise targeting of specific areas of interest on the object surface.

The optical sensor can work in conjunction with other components of the scanning device. For instance, the control unit and/or processing unit may be configured process the optical data in combination with the spin-spin relaxation time data to generate more detailed and informative results. The output unit may be configured to display the optical data, providing visual feedback to the operator during the scanning process.

In the case of dental applications, the optical sensor may be configured to capture images of tooth surfaces, gums, and other oral tissues. These images can be used to identify specific teeth or areas of interest, guide the positioning of the probe for spin-spin relaxation time measurements, and provide visual documentation of the examined areas.

The inclusion of an optical sensor in the scanning device can provide several technical advantages. For example, the acquired optical data may enable more precise positioning and navigation of the probe. The combination of optical data and spin-spin relaxation time data may provide a more comprehensive analysis of the object, potentially leading to more accurate diagnoses or assessments. Additionally, the optical data may serve as a valuable reference for interpretation of the spin-spin relaxation time results, enhancing the overall utility and effectiveness of the scanning device.

In a further embodiment, the scanning device comprises a control unit. The control unit can be configured to fuse and/or register the acquired information on the spatial position of the probe with the information on the spin-spin relaxation time.

The information on the spatial position of the probe may comprise or be in the form of spatial position data. The information on the spin-spin relaxation time of the section of the object may comprise or be in the form of spin-spin relaxation time data.

The control unit can be configured as a device or system that manages and coordinates the operations of other components within the scanning device. The control unit can comprise hardware components such as processors, memory, and interfaces, as well as software components for executing control algorithms and processing data. The control unit may comprise a processing unit, such as a processor, microcontroller, or other suitable computing device. The control unit can be configured to receive and process data from various components of the scanning device, including the sensor that acquires information on the spatial position of the probe and the high frequency system that acquires information on the spin-spin relaxation time.

Fusing the information on the spatial position of the probe with the information on the spin-spin relaxation time can involve combining or integrating these two types of data to create a comprehensive and/or interconnected dataset, e. g. a fused dataset. This fused dataset may comprise a spatial map of spin-spin relaxation times across the scanned area.

Registering information may comprise aligning, assigning and/or mapping data from different sources or coordinate systems to a common reference frame. For example, registering can involve correlating spatial position data of the probe with corresponding spin-spin relaxation time data to ensure accurate spatial localization of the acquired information on the spin-spin relaxation time.

The acquired information on the spatial position of the probe can comprise spatial position data that indicates the location and/or orientation of the probe relative to a reference point or coordinate system. The spatial position data can be obtained through various means, such as optical tracking, electromagnetic tracking, or inertial measurements according to an embodiment described above.

The information on the spin-spin relaxation time can be defined as the data representing the measured T2 relaxation times of tissues or materials of the object being examined. This information can be derived from the magnetic resonance signals detected by the scanning device and can provide insights into the molecular structure and composition of the examined object.

The control unit can be configured to perform various data processing tasks, including but not limited to:
- Synchronizing the spatial position data with the spin-spin relaxation time data.
- Applying coordinate transformations to align the spatial position data with the spin-spin relaxation time data.
- Interpolating or extrapolating data points as needed.
- Filtering or smoothing data to reduce noise or artifacts.
- Generating 2D or 3D visualizations of the fused and/or registered data.
- Storing the fused and/or registered data in a suitable format for further analysis or display.

The fusing and/or registering process can enable the creation of spatially resolved maps of spin-spin relaxation times, which can be useful for various applications such as dental diagnostics, material characterization, and/or quality control in manufacturing processes.

The fusing and/or registering of the spatial position data with the spin-spin relaxation time data may favourably allow for a more comprehensive characterization of the examined object, enabling improved analysis and interpretation of the examined tissues or materials.

The control unit and/or the processing unit may be configured to employ various algorithms and techniques to fuse and/or register the spatial position data with the spin-spin relaxation time data. These can include image registration algorithms, data fusion techniques, and spatial correlation methods. The specific algorithms used can depend on the nature of the acquired data and the desired output format.

The fused and/or registered data can be stored in a memory unit associated with the control unit and/or the processing units. This memory unit can be configured to store large datasets and can be accessible for further processing or analysis. The fused and/or registered data can facilitate more advanced analysis techniques, potentially enabling the detection of subtle patterns or anomalies that may not be apparent when examining the spatial position data and spin-spin relaxation time data separately.

The control unit and/or the processing unit can also be configured to output the fused and/or registered data. This output can be in various forms, such as a visual display on a screen, a data file for further analysis, and/or an input to another system or device, such as an output unit according to an embodiment described above.

The fusing and/or registering of the information on the spatial position of the probe with the information on the spin-spin relaxation time of the section of the object may favourably enable more precise localization of areas of interest, such as regions with abnormal spin-spin relaxation times that may indicate pathological conditions. Furthermore, the fusing and/or registering of said information may favourably allow for an assignment of measured spin-spin relaxation times to spatial positions within the object. Thus, the need for large and/or costly gradient systems configured for spatial encoding of magnetic resonance signals may favourably be eliminated.

In a second aspect, the invention relates to a method for determining a spin-spin relaxation time of an object using a scanning device according to an embodiment described above. The method comprises positioning the probe relative to a section of the object and acquiring information on the spin-spin relaxation time of the section of the object.

The object and the scanning device may be configured in accordance with an embodiment described above.

The positioning of the probe may involve placing or moving the probe to a specific location and/or orientation with respect to the object being examined. The positioning can be performed manually by an operator or automatically by a mechanical system. The probe can be positioned gradually or variably, allowing for flexibility in examining different sections of the object. The probe can be inserted into cavities or positioned near surfaces of the object, depending on the application.

A section of the object may refer to a specific area or volume of the object that is targeted for examination. In the context of dental applications, a section can be configured as a portion of a tooth, a group of teeth, or surrounding soft tissues.

Acquiring the information on the spin-spin relaxation time of the section of the object may involve measuring and collecting data related to the spin-spin relaxation time. This process may comprise generating a magnetic field, applying high frequency pulses, and detecting the resulting magnetic resonance signals.

For example, the acquisition of information on the spin-spin relaxation time can involve several sub-steps. In one sub-step, the scanning device can generate a static magnetic field using the magnet arrangement. In a further sub-step, a transmit coil of the high frequency system may emit a high frequency pulse to excite the nuclear spins in the section of the object. Following the excitation, a receive coil of the high frequency system may detect the resulting magnetic resonance signals. The magnetic resonance signals can be processed by a processing unit to extract information on the spin-spin relaxation time.

The information on the spin-spin relaxation time may be configured as spin-spin relaxation time data that represents the rate at which the transverse component of magnetization decays in the examined section of the object. This information can be used to characterize the properties of the tissue or material being examined, such as its composition, structure, or state of health.

The positioning of the probe and the acquiring of information on the spin-spin relaxation time can be interrelated steps. For example, the position of the probe may determine the section of the object from which the information on the spin-spin relaxation time is acquired. The acquired information can be used to guide further positioning of the probe for subsequent measurements.

The inventive method may offer several advantages. For example, the method may enable localized measurements of tissue properties without the need for a full-scale MRI system. This can allow for more accessible and cost-effective diagnostic capabilities in settings such as dental offices. Additionally, the method can provide valuable information about tissue characteristics, potentially aiding in the detection and diagnosis of conditions such as inflammation or other pathologies in dental structures. The method can allow for rapid and non-invasive assessment of object properties, which can be advantageous in various research and industrial applications. The inventive method shares the advantages of the inventive scanning device.

According to an embodiment, the method comprises outputting the information on the spin-spin relaxation time of the object via an output unit.

The output unit can be configured to output the information on the spin-spin relaxation time in the form of an acoustic signal, an optical signal and/or a haptic signal. For example, the output unit can be configured to provide visual, auditory, and/or tactile feedback to convey measurement results or other relevant data to an operator.

According to an embodiment, outputting the information on the spin-spin relaxation time of the object comprises outputting visual feedback on a display screen, such as an LCD, LED, or OLED display, capable of showing numerical values, graphs, or color-coded indicators representing the spin-spin relaxation time measurements. The display can be integrated into the scanning device or provided as a separate monitor.

According to a further embodiment, outputting the information on the spin-spin relaxation time of the object comprises outputting auditory feedback via a speaker or buzzer system. The auditory feedback may comprise tones or verbal cues that correspond to different ranges of spin-spin relaxation times, enabling immediate feedback without requiring an operator of the scanning device to look away from the object being examined.

According to another embodiment, outputting the information on the spin-spin relaxation time of the object comprises outputting tactile feedback via a vibration mechanism integrated into the probe or handle of the scanning device. The intensity or pattern of vibrations can be configured to indicate different measurement results, allowing for discrete feedback in noise-sensitive environments.

The information on the spin-spin relaxation time may comprise raw numerical data, processed results, or interpreted diagnostic information. The information on the spin-spin relaxation time may be output or presented in real-time as measurements are taken, or stored for later analysis and review.

The output of information on the spin-spin relaxation time via the output unit may favourably enable real-time monitoring and/or conveyance of acquired information or data. This immediate feedback can be configured to allow for on-the-spot decision making during diagnostic procedures, potentially improving efficiency and accuracy in medical or dental examinations. The format of the output can favourably be selected based on the specific needs of the application. For example, in noisy environments, the output may comprise optical signals and/or haptic signals which can easily be noticed by an operator of the scanning device.

The output from the output unit may comprise real-time updates of the spin-spin relaxation time as the probe is moved across different sections of the object, enabling the operator to quickly identify areas of interest, such as regions with abnormal spin-spin relaxation times that may indicate inflammation or other pathological conditions.

The inventive method may comprise comparing measured spin-spin relaxation times with predefined reference values or ranges to identify whether the measured values fall within normal ranges or deviate from the normal range. The outputting of the information on the spin-spin relaxation time of the section of the object may comprise alerting an operator if a scanned section of the object requires further investigation.

The outputting of the information on the spin-spin relaxation time of the object via an output unit can provide several technical advantages, such as enabling rapid and unambiguous interpretation of the acquired data, potentially improving the efficiency and accuracy of scanning examinations. Providing immediate feedback via the output unit may allow for on-the-spot decision-making regarding further diagnostic procedures or treatments. Furthermore, the ability to present complex spin-spin relaxation time data in easily understandable formats can facilitate communication between healthcare providers and patients, potentially leading to improved patient care and outcomes.

According to a further embodiment, the inventive method comprises acquiring information on a homogeneity of a magnetic field generated by the scanning device and adjusting an operating frequency of the high frequency system in dependence of the homogeneity of the magnetic field generated by the scanning device.

The homogeneity of a magnetic field may refer to the uniformity of the magnetic field strength, but also the magnetic field direction, across a predefined volume. For example, a homogeneous magnetic field may exhibit a substantially constant magnetic field strength and magnetic field direction throughout a volume of interest.

The information on the homogeneity of the magnetic field can be acquired through various means. For example, the scanning device may include a magnetometer or one or more Hall sensors configured to measure the magnetic field strength at different points within a measurement volume or examination region of the scanning device. The magnetometer or the one or more Hall sensors may be mounted on the probe.

An examination region may refer to a volume at least partially encompassed by the magnet arrangement. The examination region may be configured to accommodate the section of the object to be examined during a scanning procedure. The examination region may substantially coincide with a volume of the magnetic field generated by the magnet arrangement.

Alternatively or additionally, the homogeneity information can be based on a predetermined map of the magnetic field in conjunction of information on a spatial position of the probe. The predetermined map of the magnetic field may be obtained, for example, through simulation and/or prior measurements. The acquiring of information on the homogeneity of the magnetic field can be carried out by a control unit and/or a processing unit of the scanning device. For example, the information on the homogeneity of the magnetic field can be acquired by receiving a known homogeneity map of the magnetic field generated by the magnet arrangement from a memory or storage unit. The homogeneity map may comprise two-dimensional or three-dimensional data of the magnetic field strength generated by the magnet arrangement.

The operating frequency of the high frequency system may refer to a frequency at which the high frequency system transmits and receives signals. In magnetic resonance applications, this frequency is typically set to match the Larmor frequency of atomic nuclei being examined, which is proportional to the strength of the magnetic field.

Adjusting the operating frequency can involve changing the frequency of the high frequency pulses transmitted by the high frequency system, but also adjusting the frequency at which the high frequency system expects to receive magnetic resonance signals. This adjustment can be performed to compensate for variations in the magnetic field strength across the measurement volume, which can occur due to inhomogeneities in the magnetic field. For example, if the information on the homogeneity of the magnetic field indicates variations in the magnetic field strength across different regions of the examination region, the operating frequency of the high frequency system can be adjusted accordingly to compensate for these variations. This adjustment may favourably enable the high frequency system to maintain resonance with the nuclear spins in different regions of the object being scanned, despite variations in the local magnetic field strength.

The adjusting of the operating frequency can be performed by a control unit and/or a high frequency control unit of the scanning device. For example, the control unit and/or a processing unit can be configured to receive the acquired information on the homogeneity of the magnetic field generated by the scanning device and calculate the appropriate frequency adjustments. The adjustment of the operating frequency can be made in real-time during the scanning process, allowing for dynamic compensation of field inhomogeneities.

According to an embodiment, the adjusting of the operating frequency is made in real-time in dependence of information on the homogeneity of the magnetic field acquired via a Hall sensor mounted on the probe.

The high frequency control unit may be configured as a separate unit or can be integrated into the control unit.

Adjusting the operating frequency of the high frequency system based on known field variations may provide a means to account for and/or mitigate the effects of magnetic field inhomogeneities, which can be particularly beneficial in compact or portable scanning devices where achieving high magnetic field homogeneities may be challenging.

By adjusting the operating frequency of the high frequency system based on known field variations, the inventive method may favourably compensate for local differences in the Larmor frequency of nuclear spins, potentially improving the accuracy and/or reliability of the spin-spin relaxation time measurements across a scanned volume or examination region.

In a further embodiment, the inventive method comprises acquiring data from the sensor and determining a spatial position of the probe in dependence of the acquired data. The method may include adjusting the operating frequency of the high frequency system in dependence of the spatial position of the probe and the information on the homogeneity of the magnetic field generated by the scanning device.

The sensor can be configured to acquire information on a spatial position of the probe. The sensor may be configured in accordance with an embodiment described above. For example, the sensor may comprise an optical sensor, an ultrasound sensor, a Hall sensor, or any other suitable type of sensor for determining the spatial position of the probe.

The spatial position can include the location and/or orientation of the probe within a three-dimensional coordinate system. Determining the spatial position of the probe may comprise processing and/or analysing raw sensor data or spatial position data acquired from one or more sensors to extract the position and/or orientation of the probe.

The adjusting of the operating frequency of the high frequency system can be carried out in dependence of the spatial position of the probe and the information on the homogeneity of the magnetic field generated by the scanning device. The information on the homogeneity of the magnetic field generated by the scanning device may be acquired according to an embodiment described above.

The high frequency system can comprise a transmit coil and/or a receive coil. The adjusting of the operating frequency of the high frequency system can involve modifying the frequency of high frequency pulses emitted by the transmit coil and/or the expected frequency of magnetic resonance signals detected by the receive coil.

Adjusting the operating frequency of the high frequency system in dependence of the spatial position and the information on the homogeneity of the magnetic field generated by the scanning device may favourably allow for the compensation of local variations in the magnetic field strength, which can affect the Larmor frequency of the nuclear spins to be measured. As the probe is moved to different positions of the object, the local magnetic field strength may vary slightly due to inhomogeneities. By adjusting the operating frequency based on the known spatial position of the probe and the information on the homogeneity of the magnetic field generated by the scanning device, accurate measurement of spin-spin relaxation times across different locations within an examination region can be achieved.

This approach of dynamically adjusting the operating frequency based on probe position and field homogeneity can provide more accurate and consistent spin-spin relaxation time measurements across different regions of the object being examined. It can help account for spatial variations in the magnetic field that may otherwise lead to errors or low quality measurements.

The method for determining a spin-spin relaxation time of an object can comprise acquiring data from a sensor. The sensor can be configured to acquire information on a spatial position of a probe according to an embodiment described above.

The determining of the spatial position of the probe in dependence of the acquired data from the sensor can be carried out by a control unit and/or a processing unit of the scanning device. For example, the control unit and/or processing unit can process the data from a Hall sensor and/or an ultrasound sensor to calculate the location and/or orientation of the probe within the examination region.

The inventive method may provide several advantages. For example, the inventive method can enable accurate spin-spin relaxation time measurements in environments with non-uniform magnetic fields, expanding the usability of the inventive scanning device. Moreover, the use of one or more sensors configured to acquire data or information describing the spatial position of the probe can allow for spatial mapping of spin-spin relaxation times, potentially alleviating the need for large and costly gradient systems and/or improving diagnostic capabilities in medical and other applications. Furthermore, an adaptive adjustment of the operating frequency of the high frequency system may enhance the quality of the acquired magnetic resonance signals, potentially leading to more reliable and higher quality diagnostic information, but also allowing for the use of smaller or more compact magnet arrangements providing less uniform magnetic fields.

In a third aspect, the invention relates to a scanning device which is configured to determine a spin-lattice relaxation time (also known as T1- or longitudinal relaxation time) of an object. The scanning device comprises a probe configured to be positioned variably relative to a section of the object. The scanning device also includes a magnet arrangement and a high frequency system. The magnet arrangement comprises at least one magnet and the high frequency system comprises at least one high frequency coil. The at least one magnet and/or the at least one high frequency coil are mounted on the probe. The probe is configured to acquire information on the spin-lattice relaxation time of the section of the object.

The scanning device is configured to determine a spin-lattice relaxation time of an object. The spin-lattice relaxation time may represent a tissue-specific time constant for protons, which is a measure of the time required to realign with an external magnetic field. The spin-lattice relaxation time may indicate how quickly a spinning nuclei will emit absorbed radiofrequency signals into a surrounding tissue.

The scanning device according to the third aspect may comprise various components and systems to enable this functionality. The scanning device may be configured according to an embodiment of the scanning device according to the first aspect described above.

According to an embodiment of the invention, the scanning device is configured to determine a spin-spin relaxation time and/or a spin-lattice relaxation time of an object. The scanning device comprises a probe configured to be positioned variably relative to a section of the object. The scanning device also includes a magnet arrangement and a high frequency system. The magnet arrangement comprises at least one magnet and the high frequency system comprises at least one high frequency coil. The at least one magnet and/or the at least one high frequency coil are mounted on the probe. The probe is configured to acquire information on the spin-spin relaxation time and/or the spin-lattice relaxation time of the section of the object. The scanning device may be configured according to any of the previously described embodiments of the scanning device.

Embodiments of the invention are shown in the drawings and will be described in more detail below. The same reference numbers are used for the same features in different figures. The figures show:
- Fig. 1:: A schematic representation of an embodiment of an inventive scanning device;
- Fig. 2:: a cross-sectional view of an embodiment of a magnet arrangement of an inventive scanning device;
- Fig. 3:: a perspective view of an embodiment of an inventive scanning device;
- Fig. 4:: a perspective view of an embodiment of an inventive scanning device;
- Fig. 5:: a cross-sectional view of an embodiment of a magnet arrangement of an inventive scanning device;
- Fig. 6:: a cross-sectional view of an embodiment of a magnet arrangement of an inventive scanning device;
- Fig. 7:: a front view of an embodiment of a high frequency coil of an inventive scanning device;
- Fig. 8:: a flowchart of an embodiment of an inventive method of determining a spin-spin relaxation time of an object using a scanning device according to the invention;
- Fig. 9:: a flowchart of an embodiment of an inventive method of determining a spin-spin relaxation time of an object using an scanning device according to the invention;
- Fig. 10:: a pulse sequence diagram for acquiring information on spin-spin relaxation times of a section of an object using a scanning device according to the invention;
- Fig. 11:: a pulse sequence diagram for acquiring information on spin-spin relaxation times of a section of an object using a scanning device according to the invention.

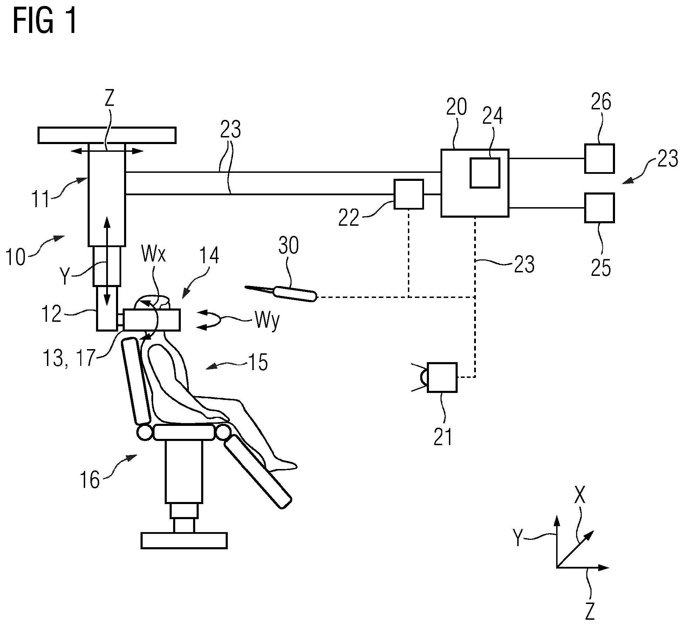

Fig. 1 depicts a schematic representation of an embodiment of an inventive scanning device 10 configured to acquire information on a spin-spin relaxation time of a section of an object.

In the present example, the scanning device 10 comprises a magnet arrangement 13 providing an examination region 14 configured to receive a section of an examination object 15, such as a body region of a patient 15. The examination region 14 is at least partially enclosed by the magnet arrangement 13. The patient 15 may access the examination region 14 by means of a patient positioning device 16.

According to an embodiment, the scanning device 10 comprises a support system 11 including an adjustment mechanism 12 configured to adjust a position and/or an orientation of the magnet arrangement 13 with respect to the patient 15. For example, the adjustment mechanism 12 may comprise a joint configured to rotate and/or move the magnet arrangement 13 along a rotation direction Wx and/or a rotation direction Wy. A position of the magnet arrangement 13 along a Y-direction and a Z-direction may be adjusted via a suitable telescope system and/or rail system incorporated within the support system 11. However, the support system 11 may be configured to adjust the position of the magnet arrangement 13 in any required direction.

The scanning device 10 depicted in Fig. 1 is mounted onto a ceiling of an examination room via the support system 11. In other embodiments, the scanning device 10 may be mounted to a floor and/or a side wall, depending on the requirements of the examination room. The illustrated embodiments of the support system 11 and the adjustment mechanism 12 are examples and not intended to limit the scope of the scanning device 10 according to the invention.

In the present example, the scanning device 10 is configured to acquire spin-spin relaxation times of a jaw region and/or an oral cavity of a patient 15. However, the scanning device 10 may also be configured to acquire information on spin-spin relaxation times of other tissues of the patient 15. For this purpose, the support system 11 and/or the adjustment mechanism 12 of the scanning device 10 may be configured to arrange the magnet arrangement 13 in proximity to different diagnostically relevant body regions of the patient 15. In some embodiments, a geometry and/or spatial position of the magnet arrangement 13 may be adjusted to fit a spatial position and/or a dimension of a specific body region of the patient 15. For example, the geometry and/or spatial position of the magnet arrangement 13 may be adjusted in such a way that the magnet arrangement 13 encompass the diagnostically relevant body region of the patient 15 from two opposite sides. According to an embodiment, the scanning device comprises an adjustment unit (not shown) configured to adjust a distance and/or orientation of at least two magnets of the magnet arrangement 13 to accommodate the diagnostically relevant body region of the patient 15.

The magnet arrangement 13 comprises at least one magnet 17 which is configured to generate a magnetic field in the examination region 14. The magnet 17 may comprise a permanent magnet and/or an electromagnet. The magnet arrangement 13 may further comprise a high frequency coil 28 (not shown in Fig. 1) configured to emit a high frequency excitation pulse into the examination region 14 and/or receive magnetic resonance signals from a section of an object positioned within examination region 14.

The scanning device 10 may comprise a control unit 20 configured to control components of the scanning device 10, such as the magnet arrangement 13 and/or the high frequency coil 28. For example, the control unit 20 may be configured to control the scanning device 10 to perform a pulse sequence for acquiring information on spin-spin relaxation times of a section of an object. For this purpose, the control unit 20 may comprise a signal connection 23 with a high frequency control unit 22 configured to control the high frequency coil 28. It is also conceivable, that the high frequency control unit 22 is integrated into the control unit 20.

The scanning device 10 comprises a probe 30 configured to be positioned variably relative to a section of an object 15 positioned within the examination region 14. The probe 30 may represent a handheld device configured to be positioned freely relative to the patient 15. In the depicted example, the probe 30 comprises at least one high frequency coil 28 (not shown), e. g. a receive coil and/or a transmit coil, mounted to a tip of the probe 30. The probe 30 may be (manually) guided along a surface of the patient 15. For example, the probe 30 may be guided along a surface within the oral cavity of the patient 15 to acquire information on spin-spin relaxation times from tissues within the oral cavity.

The control unit 20 may comprise a processing unit 24 configured to coordinate an acquisition and/or an evaluation of magnetic resonance signals or spin-spin relaxation times acquired from the section of the object within the examination region 14. It is conceivable, that the processing unit 24 is configured to analyse and/or process data such as magnetic resonance signals or spin-spin relaxation time data. The control unit 20 may comprise a controller, a microcontroller, an analog circuit, a logic unit and the like. The processing unit 24 may comprise a processor, such as a CPU, a GPU and the like. The control unit 20 and/or the processing unit 24 may further comprise a memory and/or a storage unit, such as a RAM, a ROM, a PROM, an EPROM, an EEPROM, a flash memory, as well as an HDD, or an SSD.

The scanning device 10 may further comprise an output unit 25 configure to output control information, such as scanning parameters. It is also conceivable that the output unit 25 is configured to output acquired data, such as data from a sensor 21 and/or the information on the spin-spin relaxation times. In the present example, the output unit 25 comprises a monitor or screen configured to display control information and/or acquired data to an operator 29 (not shown) of the scanning device 10. The output unit 25 may be configured as a separate monitor or display. However, the output unit 25 may also be integrated into a user interface 23 and/or the probe 30.

The scanning device 10 may also comprise an input unit 26 configured to receive information and/or scanning parameters input by the operator. Such information and/or scanning parameters may pertain to parameters of a pulse sequence to be carried out, but also to information related to the patient 15. The input unit 26 may be integrated into the user interface 23.

In the embodiment illustrated in Fig. 1, the scanning device10 comprises a sensor 21 configured to acquire optical data comprising information on a spatial position of the probe 30. The sensor 21 may be embodied as a camera. The control unit 20 and/or the processing unit 24 may be configured to receive the optical data via a signal connection 23 and process the optical data to determine the spatial position of the probe 30 at a given point in time. It is conceivable that the control unit 20 and/or the processing unit 24 are configured to fuse and/or register the acquired information on the spatial position of the probe 30 with the information on the spin-spin relaxation time. Thus, the acquired spin-spin-relaxation times may be assigned to specific sections of the tissue examined using the probe 30, eliminating the need for a conventional gradient system. In certain embodiments, the scanning device 10 may comprise a different sensor 21 or an additional sensor 21, such as an optical sensor, an ultrasound sensor and/or a Hall sensor, configured to acquire information on the spatial position of the probe 30. For example, the probe 30 may comprise a Hall sensor configured to detect variations in the strength of the magnetic field generated by the magnet arrangement 13, allowing for a spatial position of the probe to be determined in dependence of a known homogeneity map of the magnetic field.

The illustrated scanning device 10 may include further components that magnetic resonance devices typically comprise. Preferably, a scanning device 10 as described herein lacks a gradient system, saving costs and space in comparison to conventional magnetic resonance devices. Thus, the scanning device 10 may favourably be installed in smaller medical facilities and practices that cannot accommodate a conventional magnetic resonance device.

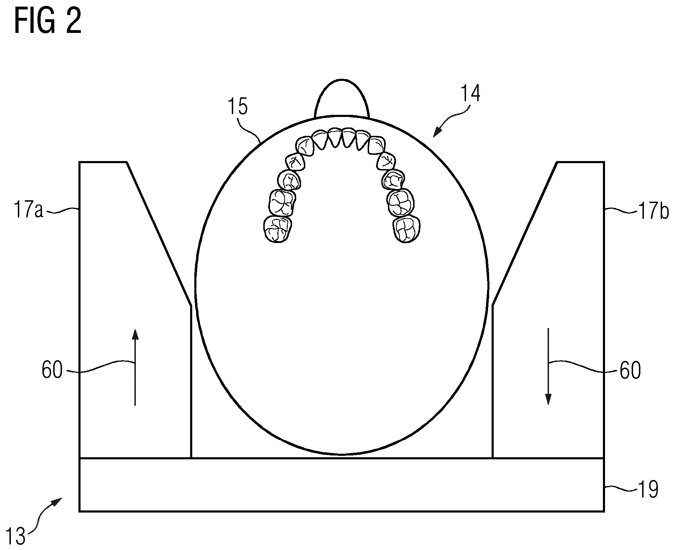

Fig. 2 shows a schematic representation of an embodiment of a magnet arrangement 13 of a scanning device 10 configured to determine a spin-spin relaxation time of an object. The magnet arrangement 13 is configured to generate a magnetic field in the examination region 14. In the depicted example, the magnet arrangement 13 comprises a first magnet 17a and a second magnet 17b, which are connected by a yoke 19. The yoke 19, the first magnet 17a and the second magnet 17b form a U-shaped or concave structure configured to accommodate a body region of a patient 15. The first magnet 17a and the second magnet 17b enclose or delimit the body region of the patient 15 from two opposing sides. The first magnet 17a and the second magnet 17b may comprise or consist of permanent magnets. It is conceivable that the first magnet 17a and the second magnet 17b are polarized in opposite directions as indicated by the arrows.

The magnet arrangement 13 can be configured to encompass an external surface of an object, such as a head of a patient 15. In the example of Fig. 2, the first magnet 17a and the second magnet 17b are arranged in such a way to project a magnetic field into the examination region 14. The examination region 14 can be designed to accommodate a section of the patient 15, such as a portion of the jaw or oral cavity. The examination region 14 may refer to a space or volume which is at least partially encompassed by the magnet arrangement 13. It is conceivable that the examination region 14 comprises a portion of the magnetic field that is most uniform or homogenous.

The U-shaped configuration of the magnet arrangement 13 may allow for easy access to a surface of a section of a patient 15 positioned within the examination region 14. The U-shaped configuration may also provide a relatively uniform magnetic field within the examination region 14.

The magnet arrangement 13 depicted in Fig. 2 may be particularly suitable for dental applications, as it can encompass the jaw area of the patient without obstructing access to the oral cavity (e. g. without preventing the probe 30 to be inserted into the oral cavity).

The yoke 19 may be configured to complete a magnetic circuit between the first magnet 17a and the second magnet 17b, enhancing the efficiency and uniformity of the magnetic field. The yoke 19 may comprise or consist of a ferromagnetic material, such as iron.

The shape and positioning of the magnets 17a and 17b within the magnet arrangement 13 can be optimized to project a magnetic field with a predefined uniformity at a specific distance from surfaces of the magnets 17a and 17b oriented towards the examination region 14.

A magnet arrangement 13 as shown in Fig.1 or Fig. 2 may be configured to generate a magnetic field strength of 50 mT to 500 mT, or 50 mT to 100 mT. Magnetic field strengths in the specified range can be suitable for measuring magnetic resonance signals or spin-spin relaxation times in different applications, such as dental applications.

In alternative embodiments, the magnet arrangement 13 may comprise an electromagnet instead of a permanent magnet. An electromagnet may allow for adjustable magnetic field strengths and potentially more flexible positioning options.

The scanning device 10 can also include a high frequency system (not shown) comprising one or more high frequency coils. At least one high frequency coil (not shown) can be mounted on the probe 30 (not shown) of the scanning device 10. In some configurations, at least one high frequency coil (not shown) can be formed as a surface coil configured to encompass an external surface of the object or patient.

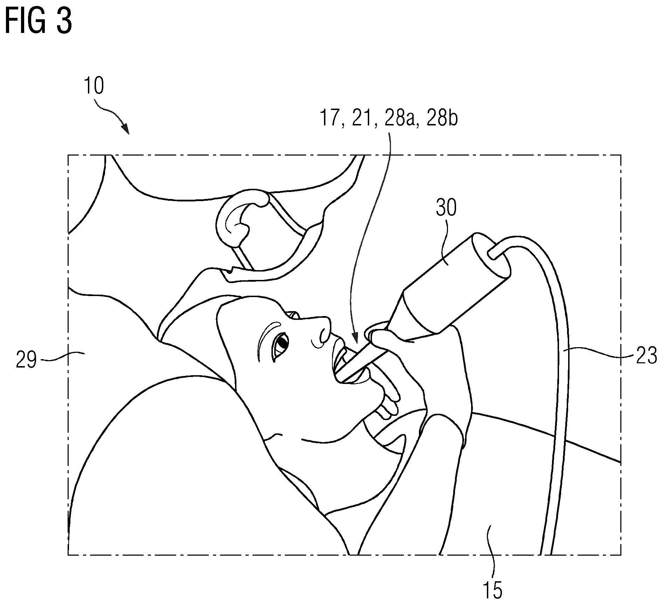

Fig. 3 shows a schematic representation of an embodiment of a scanning device 10 configured to determine a spin-spin relaxation time of an object. The scanning device 10 comprises a probe 30 configured to be positioned variably relative to a section of the object. In the depicted example, the probe 30 is configured to be inserted into an oral cavity of a patient 15 and to acquire spin-spin relaxation times of a tissue within the oral cavity of the patient 15.

The probe 30 can be configured as a handheld probe, enabling it to be positioned freely relative to the patient 15. An operator 29 may hold and manipulate the probe 30 within the patient's mouth.

The scanning device 10 can comprise a magnet arrangement 13 including a magnet 17. In the illustrated embodiment, the magnet 17 is mounted on the probe 30. The magnet 17 can be configured to generate a localized magnetic field in the vicinity of the probe tip, enabling targeted measurement of spin-spin relaxation times of a tissue inside the oral cavity of the patient 15. The magnet 17 may be configured to generate a small and/or localized magnetic field comprising a magnetic field strength between 30 mT and 200 mT, or 30 mT to 100 mT.

The scanning device 10 can further comprise a high frequency system comprising at least one high frequency coil 28. The high frequency system may comprise a receive coil 28b and a transmit coil 28a. In the embodiment depicted in Fig. 3, both the receive coil 28b and the transmit coil 28a are mounted on the probe 30. The transmit coil 28a can be configured to emit radiofrequency pulses to excite the tissue within the magnetic field generated by the magnet 17, while the receive coil 28b can be configured to detect the resulting magnetic resonance signals.

Furthermore, a sensor 21 can be integrated into the probe 30. The sensor 21 can be configured to acquire information on a spatial position of the probe 30. In the depicted example, the sensor 21 may be configured as an optical sensor mounted on the probe 30 and configured to acquire optical data from a surface within the oral cavity of the patient 15. For example, the sensor 21 can comprise an optical camera configured to acquire optical data from the oral cavity of the patient 15. In certain embodiments, the probe 30 can be combined with or integrated into an optical tooth surface scanner.

The probe 30 can be connected via a signal connection 23 to an external control unit 20 and/or processing unit 24 as shown in Fig. 1. This connection can allow for transmission of acquired data and control signals between the probe 30 and other components of the scanning device 10. According to an embodiment, the processing unit 24 is configured to fuse and/or register the optical data acquired via the sensor 21 with the information on the spin-spin relaxation time acquired from tissue within the oral cavity of the patient 15.

The compact design of the probe 30 can allow for a portable and user-friendly device that can be easily manoeuvred within a dental office setting. The scanning device 10 can enable localized measurement of tissue properties without the need for a full-scale magnetic resonance system comprising magnets encompassing a body region of a patient.

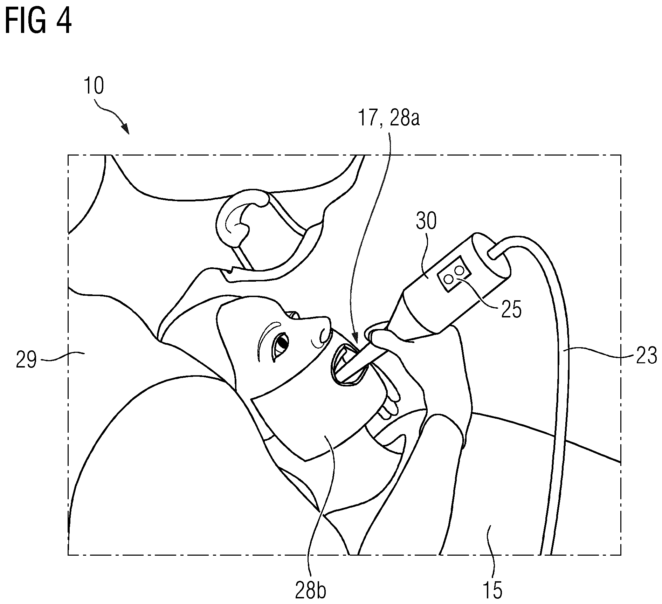

Fig. 4 shows a schematic representation of a further embodiment of a scanning device 10 for determining a spin-spin relaxation time of tissues within an oral cavity of a patient 15. In the present example, the scanning device 10 comprises a probe 30 configured to be positioned within an oral cavity of the patient 15. The probe 30 includes a magnet 17 and a transmit coil 28a mounted at its tip. The high frequency system of the scanning device 10 comprises a receive coil 28b configured as a surface coil encompassing the patient's jaw area. This embodiment enables the transmit coil 28a to generate a high frequency pulse within the oral cavity of the patient 15, while the receive coil 28b covers the patient's jaw are to detect the resulting magnetic resonance signals. By arranging the receive coil 28b outside of the oral cavity, a larger coil and/or a matrix of coils can be used, which can allow for an increase in signal-to-noise-ratio compared to a scenario where a more compact receive coil is mounted on the tip of the probe 30.

The probe 30 may be configured as a handheld device enabling the operator 29 to flexibly position the probe 30 relative to specific areas of interest within the patient's mouth. However, the handheld probe 30 can also be used to examine other areas of a patient or an object.

In the present example, the probe 30 comprises an output unit 25, which is configured to display or otherwise communicate information on the acquired spin-spin relaxation time to the operator 29. The output unit 25 may be configured to provide visual, auditory, and/or haptic feedback (e. g. in the form of an acoustic signal, an optical signal and/or a haptic signal). For example, the output unit 25 may comprise one or more coloured LEDs indicating whether a measured spin-spin relaxation time is within an expected range or outside the expected range. Thus, the operator 29 can be informed if an acquired spin-spin relaxation time is abnormal and/or outside an expected range.

The probe 30 may comprise a signal connection 23 configured to transmit data between the probe 30 and other components of the scanning device 10, such as a control unit 20, a processing unit 24 and/or a high frequency control unit 22 (see Fig. 1).

In certain embodiments of the scanning device 10, the transmit coil 28a can be formed as a surface coil configured to encompass an external surface of the object. Similarly, the receive coil 28b can be formed as a surface coil configured to encompass an external surface of the object.

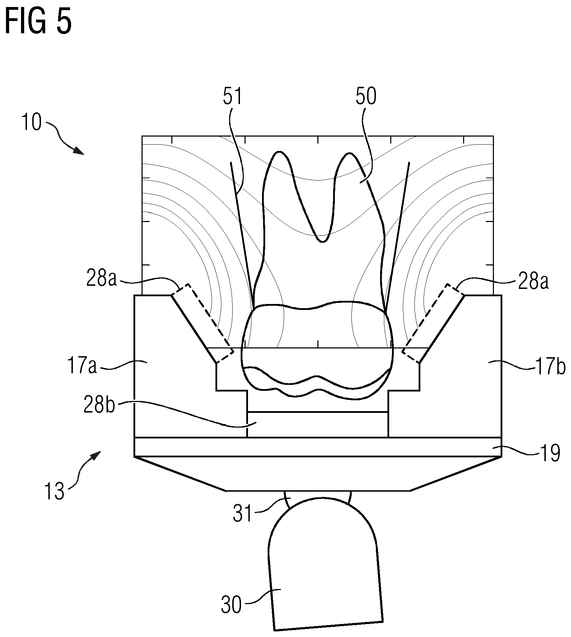

Fig. 5 shows a schematic representation of an embodiment of a probe 30 of a scanning device 10 configured to determine a spin-spin relaxation time of an object. The probe 30 comprises a magnet arrangement 13 mounted to a tip of the probe 30. The magnet arrangement 13 includes a first magnet 17a and a second magnet 17b connected by a yoke 19. The first magnet 17a and the second magnet 17b can be arranged to form a U-shaped or concave configuration configured to encompass a portion of a tooth 50 and/or a gingiva of a patient 15.

The magnet arrangement 13 can be connected to the probe 30 via a joint 31, which may be configured to enable adjustment of a spatial position of the magnet arrangement 13 relative to a shaft of the probe 30. This configuration may facilitate positioning the magnet arrangement 13 correctly near a tooth 50 and/or a section of the gingiva to be examined.

The magnet arrangement 13 can be configured to project a magnetic field at a predefined distance from the tip of the probe 30. The magnetic field generated by the magnet arrangement 13 may exhibit a magnetic field strength of 30 mT to 200 mT.

The U-shaped or concave configuration of the magnet arrangement 13 may enable the magnet arrangement 13 to encompass an external surface of the object, such as a portion of a tooth 50 or gingiva 51.

The yoke 19 of the magnet arrangement 13 may serve to complete the magnetic circuit between the first magnet 17a and the second magnet 17b, enhancing the efficiency and uniformity of the magnetic field in a region of interest. Fig. 5 illustrates an exemplary distribution of magnetic field lines of the magnetic field provided by the magnet arrangement 13.

In certain embodiments, a transmit coil 28a and/or a receive coil 28b can be mounted on the probe 30. The transmit coil 28a and/or a receive coil 28b may represent high frequency coils which form parts of the high frequency system used for generating and detecting magnetic resonance signals. In the depicted example, two transmit coils 28a are arranged on inclined surfaces of the magnets 17a and 17b, while a receive coil 28b is mounted on a portion of the yoke 19 carrying the magnets 17a and 17b. In certain embodiments, the positions of the transmit coils 28a and the receive coil 28b as depicted in Fig. 5 may be swapped. In other embodiments, the transmit coil 28a and/or the receive coil 28b may be formed as surface coils configured to encompass an external surface of the object or patient.

A probe 30 mounting a magnet 17 or a magnet arrangement 13 as shown in Fig. 5 may be configured to enable measurement of tissue volumes between 0.5 cm³ and 2 cm³ or up to 3 cm³. Such a volume can be suitable for examining dental structures and surrounding tissues. The probe 30 may allow for placement of the magnet arrangement 13 in proximity to a tooth 50 and gingiva 51, allowing for localized measurement of the spin-spin relaxation time in the tissues near the tooth root and gum area.

The compact design of the probe 30 and the adjustable positioning of the magnet arrangement 13 via the joint 31 may favourably enable flexible and precise placement for dental diagnostics.

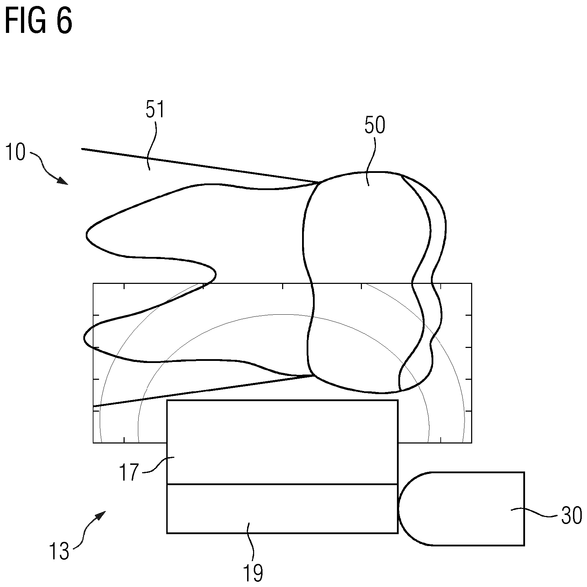

Fig. 6 shows a schematic representation of a section of an embodiment of a probe 30 of a scanning device 10 similar to the embodiment depicted in Fig. 5.

The probe 30 comprises a magnet arrangement 13 that includes a magnet 17 carried by a yoke 19. The magnet 17 can be configured as an electromagnet or a permanent magnet. For example, the magnet 17 may be configured as a single bar magnet. It is also conceivable that the magnet arrangement 13 comprises at least two magnet segments, which are polarized in opposite directions (see Fig. 2). The magnet arrangement 13 can be configured to generate a localized magnetic field having a magnetic field strength of 30 mT to 200 mT. Fig. 6 shows a schematic depiction of magnetic field lines of a localized magnetic field generated by the magnet 17 in the vicinity of a tooth 50. The probe 30 may comprise a moveable joint 31 (see Fig. 5) configured to enable adjustment of a spatial position of the magnet 17 relative to a shaft of the probe 30. In certain embodiments, a yoke 19 may be omitted.

The probe 30 is mechanically connected to the magnet arrangement 13. The magnet arrangement 13 can be configured to be inserted into an oral cavity of a patient and to generate a localized magnetic field in the vicinity of a tooth 50 and surrounding gingiva 51. In certain embodiments, the magnet arrangement 13 is configured to generate a magnetic field at a predefined distance from the tip of the probe 30.

The probe 30 can be configured to be movable relative to the tooth 50 and gingiva 51, enabling targeted measurements of spin-spin relaxation times in specific areas inside the oral cavity of a patient 15. The probe 30 can be configured to be arranged in close proximity to a tooth 50 and/or the gingiva 51, demonstrating its ability to access and scan specific areas within the oral cavity. This positioning enables localized measurement of the spin-spin relaxation time in the tissues near the tooth root and gum area.

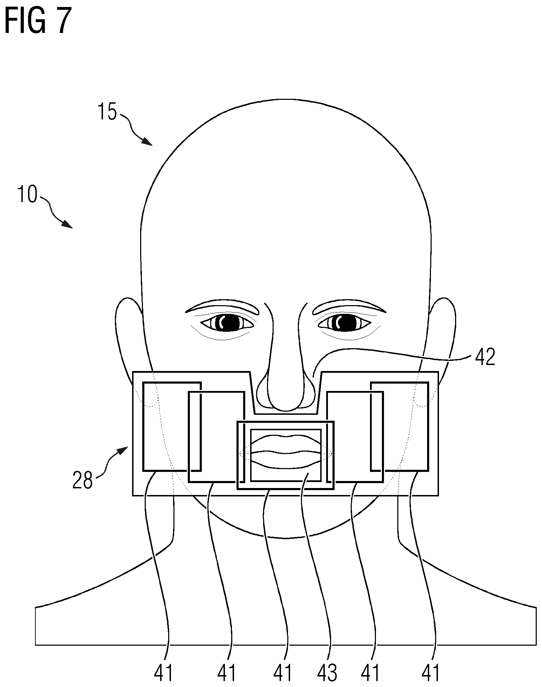

Fig. 7 shows a schematic representation of an embodiment of a high frequency coil 28 of an inventive scanning device 10 configured to determine a spin-spin relaxation time of an object. In the depicted example, the high frequency coil 28 is formed as a surface coil and configured to encompass an external surface of an object, such as a head or jaw region of a patient 15. The high frequency coil 28 may be shaped to conform to the contours of the jaw region of the patient 15.

The high frequency coil 28 can include one or more antenna elements 41. In an embodiment, the high frequency coil 28 can comprise multiple antenna elements 41 arranged adjacent to each other or partially overlapping. An arrangement of multiple antenna elements 41 can enhance the signal reception capabilities of the scanning device 10.

The high frequency coil 28 can be configured to include a recess 42 and an opening 43. The recess 42 can be designed to accommodate facial features of the patient 15, such as the eyes and/or the nose. The opening may be configured to allow access to the oral cavity of the patient 15 via the probe 30. Particularly, the opening 43 can enable the probe 30 to be inserted into the oral cavity of the patient 15. The opening 43 may also allow for visual inspection of dental structures and provide access for other dental instruments.

The high frequency system of the scanning device 10 can comprise a receive coil and a transmit coil. In the embodiment depicted in Fig. 7, the high frequency coil 28 is configured as a receive coil comprising an array of antenna elements 41 covering the jaw area of the patient 15. Alternatively or additionally, the high frequency coil 28 may be configured as a transmit coil. For example, the high frequency coil 28 may be configured emit high frequency pulses into the jaw region of the patient 15. In some embodiments, antenna elements 41 of the receive coil may also act as transmit coil. In other embodiment, the high frequency coil 28 may comprise a receive coil and a transmit coil arranged in different layers of a structure of the high frequency coil. Both the receive coil and the transmit coil can be formed as surface coils configured to encompass an external surface of the object, such as the patient's jaw region.

The surface coil design may allow for improved signal-to-noise ratio compared to smaller coils that might be mounted on the probe 30. By conforming to the external surface of the object, these coils can provide coverage of a larger area while maintaining proximity to the region of interest.

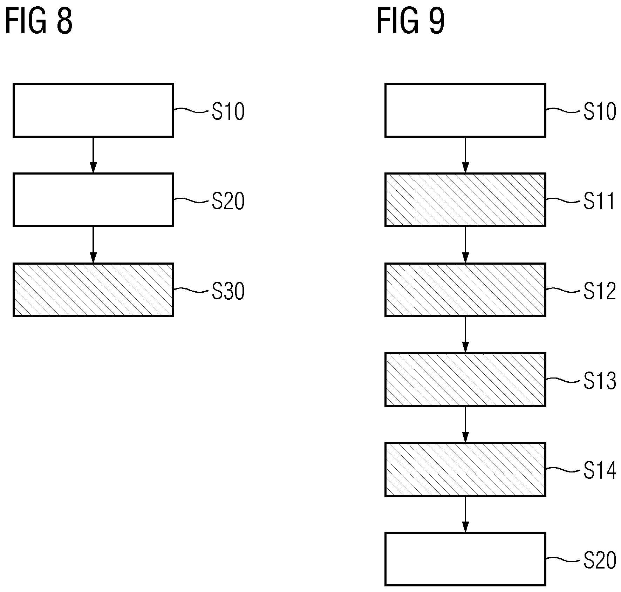

Fig. 8 shows a flow chart of an embodiment of an inventive method for determining a spin-spin relaxation time of an object using a scanning device 10. The method can comprise multiple steps that can be executed in a sequential manner.

In a step S10, the probe 30 can be positioned relative to a section of the object. For example, the probe 30 can be arranged inside an oral cavity of a patient 15 to scan sections of one or both dental arches and/or the gingiva of the patient 15 for inflammations and/or other abnormalities. The probe 30 can be configured to be positioned freely relative to the section of the object, allowing for flexible examination of different areas within the oral cavity.

In a step S20, information on the spin-spin relaxation time of the section of the object can be acquired. The acquiring of the information on the spin-spin relaxation time can involve carrying out a CPMG (Carr-Purcell-Meiboom-Gill) sequence. The CPMG sequence can be configured to measure the transverse relaxation time T2, which can provide information about the tissue properties in the examined area.

In an optional step S30, the information on the spin-spin relaxation time of the object can be output via an output unit 25. The output unit 25 can be configured to output the information in the form of an acoustic signal, an optical signal and/or a haptic signal. Outputting the information on the spin-spin relaxation time can enable immediate feedback to the operator during a scanning procedure.

It is conceivable that the information on the spin-spin relaxation time of the object is analysed or processed by the control unit 20 and/or the processing unit 24 (see Fig. 1) to extract key information that can be conveyed to an operator 29. For example, the information on the spin-spin relaxation time of the object can be processed in such a way that the output comprises an information on whether the spin-spin relaxation time is within or outside an expected range, or whether the operator 29 should further examine a section of the object (e. g. via the scanning device 10, but also via other diagnostic means). The information on the spin-spin relaxation time of the object may also be processed in such a way that the output comprises a visual representation of the measured spin-spin relaxation times, e. g. in the form of a graph and/or in conjunction with a graphical representation of the scanned section of the object. The graphical representation of the scanned section of the object may comprise optical data of a dental structure of the patient 15 acquired via a sensor 21 (see Fig. 1).

Additionally, the method can comprise further steps that are not explicitly shown in Fig. 8. For instance, additional steps of acquiring data from a sensor 21 and fusing and/or registering the data acquired from the sensor 21 with the information on the spin-spin relaxation time can be included.

According to an embodiment, the sensor 21 can be configured to acquire optical data of the section of the object, such as the teeth and/or the gingiva of a patient 15. This can be followed by a step of fusing or registering the acquired optical data with the information on the spin-spin relaxation times via the processing unit 24. The fused or registered data may be output to the operator 29 via the output unit 25. The information on the spin-spin relaxation times can be assigned to corresponding sections of the scanned area of the object from which the data was obtained. Thus, a further context of an origin of the measured spin-spin relaxation times may be provided in addition to the manual positioning of the probe via the operator 29. Moreover, a fusing or registering of the optical data and the information on the spin-spin relaxation times may allow for the two data sets to be stored as correlated data for future review, but also eliminate the need for a dedicated gradient system for encoding of spatial information.

Fig. 9 shows a flow chart of a further embodiment of an inventive method for determining a spin-spin relaxation time of an object using a scanning device 10 according to the invention.

In a step S10, the probe 30 can be positioned in proximity to a section of the object to be scanned. For example, the probe 30 can be inserted into an oral cavity of a patient 15 and positioned near a tooth or gum tissue.

An optional step S11 may involve acquiring information on a homogeneity of a magnetic field generated by the scanning device 10. The information on the homogeneity of the magnetic field may represent a priori information obtained from a storage unit or a memory of the control unit 20 and/or the processing unit 24. For example, the information on the homogeneity of the magnetic field may comprise a known homogeneity map of the magnetic field obtained via simulation and/or by measurement of the magnetic field using a magnetometer and/or Hall sensor.

In an optional step S12, data can be acquired from a sensor 21. The sensor 21 can be configured to acquire information on a spatial position of the probe 30. For example, the sensor 21 may comprise an optical sensor, an ultrasound sensor, and/or a Hall sensor according to an embodiment described above.

A further optional step S13 may involve determining a spatial position of the probe 30 in dependence of the acquired data from the sensor 21. This determination can be performed by a control unit 20 and/or a processing unit 24 of the scanning device 10.

In an example, the sensor 21 comprises a Hall sensor. The Hall sensor can be configured to measure a local magnetic field strength within the examination region 14 (see Fig. 1). The measured local magnetic field strength can be used to determine the spatial position of the probe 30, particularly the Hall sensor, relative to a known magnetic field distribution (e. g. a predetermined magnetic field map or the homogeneity map of the magnetic field obtained in the optional step S11) generated by the magnet arrangement 13 of the scanning device 10.

In another example, the sensor 21 comprises an ultrasound sensor. The ultrasound sensor can be configured to acquire information on the spatial position of the probe 30. For instance, the ultrasound sensor can emit ultrasonic waves and detect reflections from surrounding structures to determine the position and/or orientation of the probe 30 relative to the examination area 14 and/or the object being examined.

In an optional step S14, an operating frequency of the high frequency system can be adjusted. The adjusting of the operating frequency of the high frequency system can be carried out in dependence of the determined spatial position of the probe 30 and the information on the homogeneity of the magnetic field generated by the scanning device 10. The adjustment of the operating frequency of the high frequency system can compensate for local magnetic field variations that may affect the Larmor frequency of the spins to be measured.

The step S20, may involve acquiring information on the spin-spin relaxation time of the section of the object in accordance with an embodiment described above. The acquiring of information on the spin-spin relaxation time can involve performing a Carr-Purcell-Meiboom-Gill (CPMG) sequence or a spin-echo CPMG (SE-CPMG) sequence.

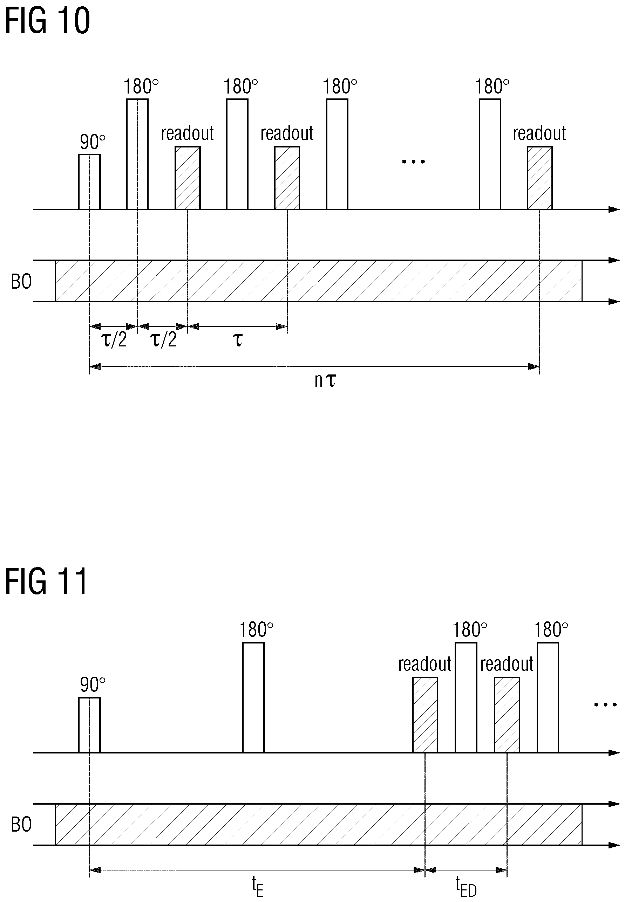

Fig. 10 shows a schematic representation of an embodiment of a pulse sequence for acquiring information on the spin-spin relaxation time of a section of an object using a scanning device 10 according to the invention. The diagram illustrates the timing and amplitudes of various high frequency pulses and signal readouts over time.

The scanning device 10 can be configured to use a CPMG (Carr-Purcell-Meiboom-Gill) sequence to measure the spin-spin relaxation time. This sequence can be particularly useful for obtaining T2-weighted information about soft tissues in a scanned area or examination region 14.

In the CPMG sequence, a 90° pulse can be applied via a transmit coil, followed by a series of 180° pulses spaced at regular intervals. Between these high frequency pulses, readout periods can be included where a magnetic resonance signal is acquired via a receive coil. The sequence can be repeated multiple times, with each repetition comprising a 180° pulse and a subsequent signal readout.

A constant magnetic field (B0-field) can be applied throughout the entire sequence, represented by a horizontal bar at the bottom of the diagram. For example, the constant magnetic field can be generated by a permanent magnet of the scanning device 10. Alternatively, the constant magnetic field can be a pulsed magnetic field generated by an electromagnet of the scanning device 10.

The time intervals of the pulse sequence are marked on the horizontal axis of the diagram, including a τ/2 period between the initial 90° pulse and the 180° pulse, and a τ period between subsequent 180° pulses or between the readouts. The total duration of the pulse sequence may amount to nτ. The τ value can be adjusted based on the specific requirements of the measurement and the characteristics of the tissue being examined.

The CPMG sequence may provide good T2 contrast when used in conjunction with the scanning device 10. This can be particularly beneficial for detecting inflammations or other pathologies in dental tissues, where subtle changes in T2 contrast can be indicative of disease.

Fig. 11 shows a schematic representation of a pulse sequence diagram for acquiring information on the spin-spin relaxation time of a section of an object using a scanning device 10 according to the invention. The diagram depicts a SE-CPMG (Spin Echo - Carr-Purcell-Meiboom-Gill) sequence, which can be used for diffusion-relaxation measurements.

The SE-CPMG sequence can comprise a preparation sequence followed by a train of refocusing pulses. The preparation sequence can be configured to encode diffusion, while the train of refocusing pulses can be configured to encode the T2 relaxation.

As shown in Fig. 11, the pulse sequence can begin with a 90° pulse, which is followed by a 180° pulse. The 90° pulse and the 180° pulse are emitted via a transmit coil of the high frequency system. A first readout can occur at *t_{E}* (echo time) after the 180° pulse. The first readout can be followed by further 180° pulses and readouts at regular intervals (*t_{ED}*).

A magnetic field B0 can be applied throughout the entire sequence. The magnetic field B0 can be generated by a permanent magnet or an electromagnet of the scanning device 10. In Fig. 11, the magnetic field B0 is represented as a constant line throughout the sequence.

The SE-CPMG sequence can enable the scanning device 10 to measure both diffusion and T2 relaxation. This can be particularly advantageous for detecting and characterizing inflammations or other pathologies in dental tissues, as both diffusion and T2 relaxation can provide valuable information about tissue properties.

When carrying out a CPMG sequence or a SE-CPMG sequence, the operating frequencies of the high frequency system can be adjusted in accordance with a method as described above. This adjustment can compensate for local magnetic field variations which may cause local variations of the Larmor-frequency of nuclear spins to be measured. Furthermore, the CPMG sequence and the SE-CPMG sequence can be optimized for a specific magnetic field strength and a magnetic field distribution of the compact magnet arrangement 13 used in the scanning device 10, allowing for efficient data acquisition in smaller medical facilities and practices, such as dental offices.

The schematic representations depicted in the figures do not represent any scale or size relationships.

The methods and devices described in detail above are merely exemplary embodiments which can be modified in a variety of ways by those skilled in the art without departing from the scope of the invention. Particularly, individual embodiments may be extended by or combined with features of other embodiments if not explicitly stated otherwise. Furthermore, the steps of the method according to the invention are not limited to a described order. Some steps can be carried out in a different order and/or partially or completely overlap in time.

Furthermore, the use of the indefinite articles "a" or "an" does not preclude that individual features in question can also be present multiple times. Likewise, the terms "unit" and "element" do not preclude that the components in question consist of several interacting sub-components which can also be spatially distributed if necessary.

In the context of the present application, the expression "based on" can be understood in particular in the sense of the expression "using". In particular, a formulation according to which a first feature is generated based on a second feature (alternatively: determined, determined, etc.) does not exclude the fact that the first feature can be generated based on a third feature (alternatively: determined, determined, etc.).

## Claims

1. A scanning device (10) configured to determine a spin-spin relaxation time of an object, comprising:
a probe (30) configured to be positioned variably relative to a section of the object;
a magnet arrangement (13) comprising at least one magnet (17); and
a high frequency system comprising at least one high frequency coil (28);
wherein the at least one magnet (17) and/or the at least one high frequency coil (28) are mounted on the probe (30), and wherein the probe (30) is configured to acquire information on the spin-spin relaxation time of the section of the object.

2. The scanning device (10) according to claim 1, wherein a section of the probe (30) comprising the at least one magnet and/or the high frequency coil is configured to be inserted into an oral cavity of a patient (15) and to determine a spin-spin relaxation time of a tissue within the oral cavity of the patient (15).

3. The scanning device (10) according to claim 1 or 2, wherein the probe (30) is a handheld probe configured to be positioned freely relative to the section of the object.

4. The scanning device (10) according to any of the preceding claims, wherein the magnet arrangement (13) is configured to encompass an external surface of the object, and wherein the at least one high frequency coil (28) is mounted on the probe (30).

5. The scanning device (10) according to any of claims 1 to 3, wherein the at least one magnet (17) is mounted on the probe (30).

6. The scanning device (10) according to claim 5, wherein the at least one magnet (17) is a unilateral magnet configured to project a magnetic field at a predefined distance from a tip of the probe (30).

7. The scanning device (10) according to any of claims 4 to 6, wherein the high frequency system comprises a receive coil (28b) and a transmit coil (28a), wherein the receive coil (28b) is mounted on the probe (30), and wherein the transmit coil (28a) is formed as a surface coil configured to encompass an external surface of the object.

8. The scanning device (10) according to any of claims 4 to 6, wherein the high frequency system comprises a receive coil (28b) and a transmit coil (28a), wherein the transmit coil (28a) is mounted on the probe (30), and wherein the receive coil (28b) is formed as a surface coil configured to encompass an external surface of the object.

9. The scanning device (10) according to claim 5 or 6, wherein the high frequency system comprises a receive coil (28b) and a transmit coil (28a), and wherein the receive coil (28b) and the transmit coil (28a) are formed as surface coils configured to encompass an external surface of the object.

10. The scanning device (10) according to any of the preceding claims, further comprising an output unit (25) configured to output the information on the spin-spin relaxation time on the section of the object in the form an acoustic signal, an optical signal and/or a haptic signal.

11. The scanning device (10) according to any of the preceding claims, further comprising a sensor (21) configured to acquire information on a spatial position of the probe (30).

12. The scanning device (10) according to claim 11, comprising an optical sensor, wherein the optical sensor is mounted on the probe (30) and configured to acquire optical data from a surface of the section of the object.

13. The scanning device (10) according to any of claims 10 to 12, further comprising a control unit (20), wherein the control unit (20) is configured to fuse and/or register the acquired information on the spatial position of the probe (30) with the information on the spin-spin relaxation time.

14. A method for determining a spin-spin relaxation time of an object using a scanning device (10) according to one of the preceding claims, comprising:
• positioning (S10) the probe (30) relative to a section of the object; and
• acquiring (S20) information on the spin-spin relaxation time of the section of the object.

15. The method according to claim 14, comprising:
• outputting (S30) the information on the spin-spin relaxation time of the object via an output unit (25).

16. The method for determining a spin-spin relaxation time of an object using a scanning device (10) according to claim 4, further comprising:
• acquiring (S11) information on a homogeneity of a magnetic field generated by the scanning device (10); and
• adjusting (S14) an operating frequency of the high frequency system in dependence of the homogeneity of the magnetic field generated by the scanning device (10).

17. The method for determining a spin-spin relaxation time of an object according to claim 16 using a scanning device according to claim 11, further comprising:
• acquiring (S12) data from the sensor; and
• determining (S13) a spatial position of the probe in dependence of the acquired data;
wherein the adjusting (S14) of the operating frequency of the high frequency system is carried out in dependence of the spatial position of the probe and the information on the homogeneity of the magnetic field generated by the scanning device.
